# EUROPEAN PATENT APPLICATION

(11) **EP 2 055 811 A2**
(43) Date of publication of application: **06.05.2009**
(21) Application number: 08018393.2
(22) Date of filing: 21.10.2008
(51) Int. Cl.: C30B 11/00, C30B 15/20, C30B 15/26, C30B 25/04, H01L 29/772, C30B 29/40

(54) **Nitride semiconductor substrate and method of manufacturing the same and field-effect transistor**

(30) Priority: 24.10.2007 JP 2007275889; 24.04.2008 JP 2008113287
(71) Applicant: Sumitomo Electric Industries, Ltd., Osaka-shi, Osaka 541-0041 (JP)
(72) Inventor: Sato, Fumitaka, Itami-shi Hyogo 664-0016 (JP); Nakahata, Seiji, Itami-shi Hyogo 664-0016 (JP); Kiyama, Makoto, Osaka 554-0024 (JP)
(74) Representative: Grünecker, Kinkeldey, Stockmair & Schwanhäusser Anwaltssozietät

(57) **Abstract**

A method of manufacturing a semi-insulating nitride semiconductor substrate includes the steps of forming on an underlying substrate (1), a mask (3) in which dotted or striped coating portions having a width or a diameter Ds from 10µm to 100µm are arranged at an interval Dw from 250µm to 2000µm, growing a nitride semiconductor crystal (5) on the underlying substrate (1) with an HVPE method at a growth temperature from 1040°C to 1150°C by supplying a group III raw material gas and a group V raw material gas of which group V/group III ratio R_{5/3} is set to 1 to 10 and a gas containing iron, and removing the underlying substrate (1), to thereby obtain a free-standing semi-insulating nitride semiconductor substrate (5s) having a specific resistance not smaller than 1×10⁶Ωcm and a thickness not smaller than 100µm. Thus, the semi-insulating nitride semiconductor crystal substrate in which warpage is less and cracking is less likely can be obtained.

## Description

### BACKGROUND OF THE INVENTION

### Field of the Invention

The present invention relates to a semi-insulating nitride semiconductor substrate and a method of manufacturing the same, a nitride semiconductor epitaxial substrate, and a field effect transistor. A nitride semiconduetor refers to gallium nitride (GaN), aluminum nitride (AlN) and indium nitride (InN), as well as mixed crystals such as InGaN, AlInGaN and the like. A free-standing crystal substrate is of interest, rather than a thin film attached onto an underlying substrate. Here, GaN will mainly be discussed. As GaN has a wide bandgap, GaN is utilized as a material for a blue light-emitting element.

A light-emitting element such as a blue light-emitting diode and a semiconductor laser has conventionally been manufactured by epitaxially growing a nitride semiconductor thin film crystal, composed, for example, of InGaN, GaN, and AlInGaN on a sapphire (α-Al₂O₃) single crystal substrate. Sapphire has the hexagonal system similarly to gallium nitride. A C-face thin film composed of GaN grows on a sapphire C-face crystal.

The sapphire substrate, however, is insulating, and it is impossible to fabricate an n electrode from its bottom surface. In addition, as a cleavage plane of GaN is different from a cleavage plane of the sapphire substrate, separation should be carried out using a cutting machine, which requires time and effort and results in poor yield in chip separation.

Moreover, gallium nitride (GaN) is considerably different from sapphire in a lattice constant. A GaN crystal grown on the sapphire substrate has high dislocation density and warpage thereof is great. Here, an attempt to fabricate a substrate crystal with gallium nitride was made so that gallium nitride itself serves as the substrate. As gallium nitride has a wide bandgap, it has been considered as a material suitable for a blue light-emitting element. As it is advantageous to fabricate an n electrode from the bottom surface and a p electrode from the top in the light-emitting element, a highly conductive substrate is desired.

In manufacturing a nitride semiconductor substrate, growth of an n-type nitride semiconductor crystal high in free electron density has been aimed so far. Currently, an n-type GaN free-standing substrate having a 2-inch diameter can be manufactured. The present invention relates to growth of a semi-insulating nitride semiconductor, instead of an n-type nitride semiconductor.

In addition to such a characteristic as a wide bandgap, GaN exhibits an excellent characteristic in use for an electronic device. For example, currently, Si is used as a material for a field-effect transistor (FET) in most cases. With regard to electron mobility, a withstand voltage characteristic or the like, however, a GaN semiconductor seems to be superior to an Si semiconductor. GaN is higher than Si in electron mobility and in a breakdown voltage. If an FET can be fabricated from GaN, an FET achieving a speed, a current and a voltage higher than Si may be obtained. If a heterojunction such as AlGaN/GaN is made, electrons would be confined in the AlGaN/GaN junction interface and a two-dimensional electron gas in which electrons are two-dimensionally distributed would be generated. As there is no scattering factor in a portion where the two-dimensional gas is generated, the two-dimensional electron gas would transit at high speed.

The present invention aims to manufacture a nitride semiconductor crystal for use as a material for an FET, not as a material for an optical element as in a conventional example.

If an FET including a GaN/AlGaN thin film should be fabricated, the FET would initially be fabricated on a sapphire substrate. In the FET, drain, gate and source electrodes are formed in proximity to one another on a semiconductor layer and a current flows horizontally. Namely, the source, gate and drain electrodes should only be provided side by side on an upper surface, which is different from a light-emitting element in which a current flows vertically through the substrate.

In the case of an FET, as no problem arises in connection with an n electrode on the back surface, an insulating sapphire substrate may be employed, however, the problem of lattice unmatching still remains. In addition, the FET also has a problem of costs, and a GaN-based FET is still far from practical use.

If a GaN-FET should be fabricated, it would be preferable in terms of lattice matching to fabricate such an FET by employing a GaN crystal substrate rather than a sapphire substrate and by forming an epitaxial thin film composed, for example, of GaN, AlGaN, or the like.

A high-resistance, semi-insulating substrate rather than a highly conductive n-type substrate is desired as the substrate for the FET, and such a characteristic is significantly different from those required in a conventional GaN crystal substrate for a light-emitting element. The present invention relates to a method of manufacturing a semi-insulating GaN substrate crystal that can be employed for a substrate for an FET.

Initially, a dopant will be discussed. A thin film composed of GaN or InGaN has conventionally been employed for a blue light-emitting element. In order to attain p-type, doping with Mg or Zn is performed. In order to attain n-type, doping with Si is performed. The present inventors have first discovered that doping with oxygen should be performed in order to obtain an n-type GaN substrate. Therefore, Si and O are employed as n-type dopants. It is then necessary to determine a dopant for achieving a semi-insulating GaN crystal and fabrication conditions.

### Description of the Background Art

In forming a nitride semiconductor thin film (such as a GaN thin film, an InGaN thin film, an AlGaN thin film, and the like) on a sapphire substrate for manufacturing a light-emitting element, an MOCVD (metal-organic chemical vapor deposition) method is employed in many cases. As the vapor deposition method is employed, a raw material is provided in a gaseous form. Nitrogen is provided in a form of ammonia (NH₃). In the MOCVD method, a group III element is provided in a form of an organic metal. An organic metal of a group III element such as gallium and indium (trimethyl gallium, triethyl indium, and the like) as well as NH₃ are supplied as raw materials onto the heated sapphire substrate.

In order to form a GaN-based semiconductor thin film with the vapor deposition method, an HVPE (hydride vapor phase epitaxy) method is also often employed. In this method, a Ga boat containing a Ga metal melt is provided on a susceptor and HCl is introduced to synthesize GaCl, which is in turn used as a Ga raw material. Therefore, GaCl and ammonia are used as raw material gases.

As to a dopant, in order to make a GaN crystal semi-insulating, doping with iron (Fe) is performed. As iron (Fe) forms a deep level in a bandgap of the GaN crystal and traps n-type carriers (free electrons), carriers decrease. Accordingly, the GaN crystal becomes semi-insulating. The GaN crystal is described as semi-insulating because it is not completely insulating, however, the GaN crystal has resistivity sufficiently high for use as a substrate for an FET. In the present invention, "semi-insulating" implies having a resistivity (specific resistance) of at least 1×10⁵Ωcm, for example. As iron is introduced into a vapor-deposited nitride semiconductor, a gaseous iron compound should be employed. For example, bis(cyclopentadienyl)iron ((C₅H₅)₂Fe), bis(methylcyclopentadienyl)iron ((CH₃C₅H₄)₂Fe), or the like is employed.

International Publication WO99/23693 (hereinafter, referred to as Patent Document 1) describes a method of obtaining a thick GaN crystal by forming a GaN buffer layer on a GaAs substrate with a mask having a window diameter from 1 to 5µm and a window pitch from 4µm to 10µm being attached and by growing a GaN crystal thereon with C face being maintained, with the MOCVD method at 820°C or 970°C or with the HVPE method at 970°C, 1000°C, 1010°C, 1020°C, or 1030°C.

In Patent Document 1, a mask including a small window is employed. Fig. 1 is a plan view showing an exemplary mask 3 formed on an underlying substrate 1. In mask 3, a large number of small windows 3w are regularly arranged in a large coating portion (referring to a portion of the mask with which the underlying substrate is coated; to be understood similarly hereinafter). Underlying substrate 1 is exposed through window 3w. The coating portion of mask 3 is greater in area than an opening (window 3w) in mask 3.

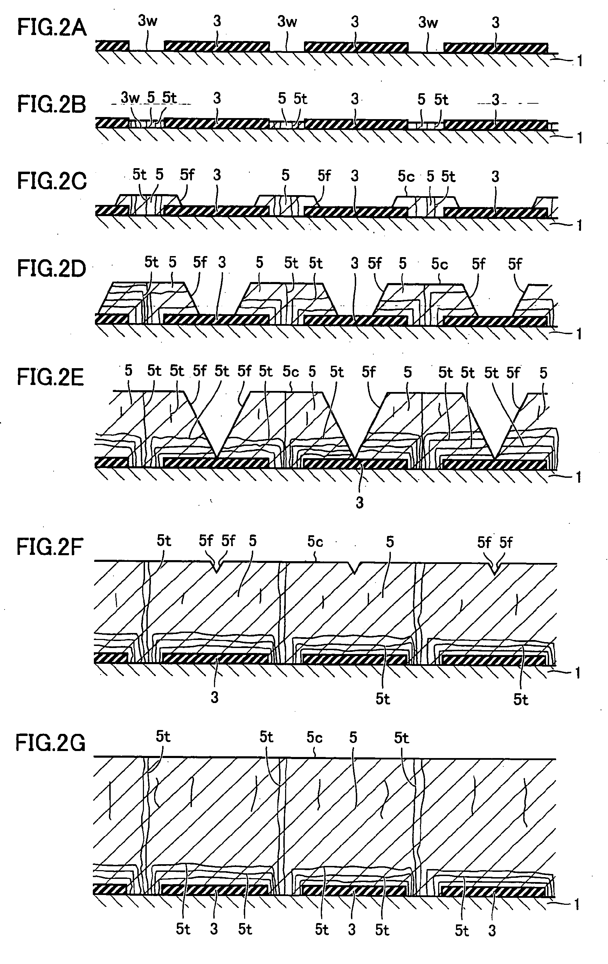

Principles of dislocation reduction during crystal growth using a mask method will be described with reference to Figs. 2A to 2G. Figs. 2A to 2G are cross-sectional views showing crystal growth steps using the mask method. As shown in Fig. 2A, mask 3 is such that a mask material is formed on underlying substrate 1 and small windows 3w are regularly provided. As shown in Fig. 2B, gallium nitride is vapor-deposited to obtain a gallium nitride crystal 5 only within window 3w. A large number of dislocations 5t threading upward are generated at the boundary between crystal 5 and underlying substrate 1.

When growth further proceeds, as shown in Fig. 2C, a part of crystal 5 in window 3w runs on mask 3 and extends laterally over mask 3. As crystal 5 grows laterally, dislocation 5t also extends laterally. A side surface serves as a facet 5f having low Miller indices. As shown in Fig. 2D, crystal 5 extends upward and in a lateral direction and forms a truncated cone shape. An upper surface of the truncated cone is a C face 5c. As shown in Fig. 2E, crystal 5 extending from one window 3w and crystal 5 extending from window 3w adjacent thereto come in contact with each other. Dislocations 5t, 5t of these crystals 5, 5 extend laterally and collide with each other. Thus, dislocations 5t, 5t cancel each other.

As shown in Fig. 2F, a groove formed by facets 5f of crystals 5 is buried and becomes smaller. A recessed portion formed by facets 5f is soon buried and a flat surface is obtained. The flat surface is C face 5c. Hereafter, growth continues with C face 5c being maintained as the surface. Dislocations 5t are located more in window 3w but less over mask 3.

As Patent Document 1 specifically shows a growth temperature or a raw material partial pressure, it is an important conventional art. Patent Document 1 describes the growth temperature as follows. When the HVPE method is employed, the growth temperature is set to 970°C, 1000°C, 1010°C, 1020°C, or 1030°C, and when the MOCVD method is employed, the growth temperature is set to 820°C or 970°C°.

In the HVPE method, the raw materials are HCl, a Ga melt, and NH₃. The Ga melt and an HCl gas are caused to react with each other, and resultant GaCl is employed as the group III raw material. An amount of supplied group III raw material and group V raw material is expressed by using a GaCl partial pressure P_{GaCl} and an NH₃ partial pressure P_{NH3}. A ratio of the group V raw material to the group III raw material R_{5/3} can be expressed as a ratio between NH₃ partial pressure P_{NH3} and GaCl partial pressure P_{GaCl}. Namely, R_{5/3} = P_{NH3}/P_{GaCl}.

The GaN crystal formed with the mask method has a specific resistance S in a range of S = 0.005Ωcm to 0.08Ωcm.

Growth conditions with the use of the MOCVD method described in the examples of Patent Document 1 are expressed by (a growth temperature Tq, NH₃ partial pressure P_{NH3}, a TMG partial pressure P_{TMG}, and group V/group III ratio R_{5/3}) as follows: (970°C, 20kPa, 0.2kPa, 100), (970°C, 25kPa, 0.2kPa, 100), (820°C, 20kPa, 0.3kPa, 67), (970°C, 20kPa, 0.2kPa, 100), (1000°C, 20kPa, 0.4kPa, 50), and (970°C, 25kPa, 0.5kPa, 50).

Growth conditions with the use of the HVPE method described in the examples of Patent Document 1 are expressed by (growth temperature Tq, NH₃ partial pressure P_{NH3}, an HCl partial pressure P_{HCl}, and group V/group III ratio R_{5/3}) as follows: (970°C, 25kPa, 2kPa, 12.5), (970°C, 25kPa, 2.5kPa, 10), (970°C, 25kPa, 0.5kPa, 50), (1000°C, 20kPa, 2kPa, 10), (950°C, 25kPa, 2kPa, 12.5), (1020°C, 25kPa, 2kPa, 12.5), (1000°C, 25kPa, 2kPa, 12.5), (1010°C, 25kPa, 2kPa, 12.5), and (1030°C, 25kPa, 2kPa, 12.5).

Japanese Patent No. 3788037 (Japanese Patent Laying-Open No. 2000-012900; hereinafter referred to as Patent Document 2) provides a free-standing GaN substrate having a diameter not smaller than 20mm, a thickness not smaller than 70µm, and a flexure (warpage) not larger than 0.55mm when converted to a 50mm-diameter example, by forming a mask having small windows in a staggered manner on a GaAs substrate, growing thereon a GaN crystal to a large thickness with the HVPE method with the C face being maintained, and removing the GaAs substrate. The flexure (warpage) of 0.55mm at the center of a wafer having a diameter of 50mm is equivalent to a radius of curvature R of approximately 600mm = 0.6m.

According to Patent Document 2, when the HVPE method is employed, growth temperature Tq is set to 970°C, 1020°C, or 1030°C, GaCl partial pressure P_{GaCl} is set to 1kPa or 2kPa (0.01 to 0.02atm), and NH₃ partial pressure P_{NH3} is set to 4kPa or 6kPa. According to Patent Document 2, when GaCl partial pressure P_{GaCl} is set to 1kPa, a crystal great in warpage and internal stress, likely to break and not suitable for use, although having a flat surface, is obtained, and a thickness not smaller than 70µm cannot be obtained.

On the other hand, according to Patent Document 2, when GaCl partial pressure P_{GaCl} is set to 2kPa, a crystal having small warpage and internal stress although having a rough surface is obtained. NH₃ partial pressure P_{NH3} is set to 6kPa, 12kPa, or 24kPa. Group V/group III ratio R_{5/3} is set to 3, 6, or 12. The radius of curvature is approximately 1m. The specific resistance is in a range from 0.0035 to 0.0083Ωcm. An n-type crystal is obtained.

Growth conditions described in the examples of Patent Document 2 are expressed by (growth temperature Tq, NH₃ partial pressure P_{NH3}, GaCl partial pressure P_{GaCl}, and group V/group III ratio R_{5/3}) as follows: (1030°C, 4kPa, 1kPa, 4), (1030°C, 6kPa, 1kPa, 6), (970°C, 6kPa, 2kPa, 3), (970°C, 6kPa, 1kPa, 6), (970°C, 6kPa, 1kPa, 6), (1020°C, 6kPa, 2kPa, 3), (1020°C, 6kPa, 2kPa, 3), (1030°C, 6kPa, 1kPa, 6), (970°C, 6kPa, 2kPa, 3), (970°C, 12kPa, 2kPa, 6), and (970°C, 24kPa, 2kPa, 12).

Japanese Patent No. 3788041 (Japanese Patent Laying-Open No. 2000-022212; hereinafter referred to as Patent Document 3) proposes a method of manufacturing a GaN free-standing single crystal substrate by forming on a GaAs substrate, a mask having dotted windows arranged in a [11-2] direction at regular intervals and displaced by half pitch in a [-110] direction, a mask having striped windows extending in the [11-2] direction, or a mask having striped windows extending in the [-110] direction, providing a buffer layer, epitaxially growing a GaN crystal with the HVPE method while maintaining the C face thereof, and removing the substrate and the mask.

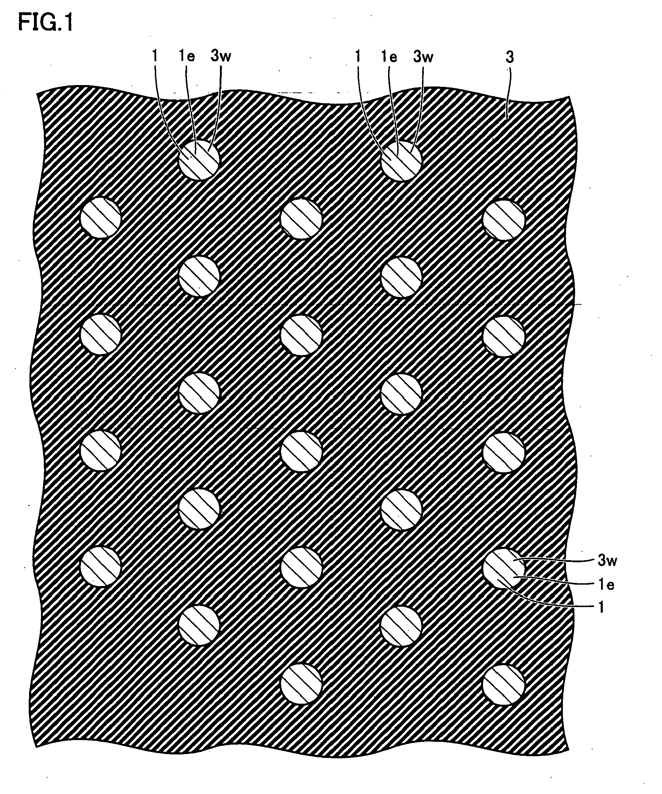

Patent Document 3 is also directed to a method of reducing dislocation in the crystal by forming the mask in which a large number of small windows as shown in Fig. 1 are arranged in rows and columns at narrow pitches on underlying substrate 1 and vapor-depositing the GaN crystal. GaCl partial pressure P_{GaCl} is set to 1kPa (0.01atm) or 2kPa (0.02atm). According to Patent Document 3, when GaCl partial pressure P_{GaCl} is set to 1kPa, a GaN crystal great in internal stress and warpage and likely to break, although having a flat surface, is obtained. According to Patent Document 3, when GaCl partial pressure P_{GaCl} is set to 2kPa, a GaN crystal having a rough surface and small internal stress and warpage and less likely to break is obtained. According to Patent Document 3, when the growth temperature is set to 1020°C or 1030°C, the surface is flat, the internal stress is great and breakage is likely. According to Patent Document 3, when the growth temperature is set to 970°C, the GaCl partial pressure is set to 2kPa and the crystal is thick, a GaN crystal having a rough surface and small internal stress and warpage is obtained. NH₃ partial pressure P_{NH3} is in a range from 6kPa to 12kPa.

In summary, according to Patent Document 3, the temperature, the GaCl partial pressure, the NH₃ partial pressure, and group V/group III ratio R_{5/3} for manufacturing the GaN crystal having small warpage, internal stress and rough surface and less likely to break are set to 970°C, 2kPa, 6 to 12kPa, and approximately 3 to 6, respectively. The specific resistance is in a range from 0,01Ωcm to 0.017Ωcm and an n-type crystal is obtained.

HVPE growth conditions described in the examples of Patent Document 3 are expressed by (growth temperature Tq, NH₃ partial pressure P_{NH3}, GaCl partial pressure P_{GaCl}, and group V/group III ratio R_{5/3}) as follows: (1030°C, 4kPa, 1kPa, 4), (1030°C, 6kPa, 1kPa, 6), (970°C, 6kPa, 2kPa, 3), (970°C, 6kPa, 1kPa, 6), (970°C, 6kPa, 1kPa, 6), (1020°C, 6kPa, 2kPa, 3), (1020°C, 6kPa, 2kPa, 3), (1030°C, 6kPa, 1kPa, 6), (970°C, 6kPa, 2kPa, 3), (970°C, 12kPa, 2kPa, 6), and (970°C, 24kPa, 2kPa, 12).

According to International Publication WO98/47170 (hereinafter referred to as Patent Document 4), two or three ELO (Epitaxial Lateral Overgrowth) masks are alternately superimposed on each other to reduce dislocations, so that an Si-doped n-type GaN crystal grows with the MOCVD method or the HVPE method while the C face being maintained. The ELO mask achieves a high dislocation density in the window and a low dislocation density over the mask. Accordingly, when the ELO masks are provided in two or three tiers such that the windows are staggered, dislocation density can be lowered. According to Patent Document 4, when the MOCVD method is used, group V/group III ratio R_{5/3} is advantageously in a range from 30 to 2000.

In the examples, a raw material gas having group V/group III ratio R_{5/3} of 1200, 2222, 1800, 1500, 800, or 30 is employed. The HVPE method is not mentioned. Si is employed as an n-type dopant. A silane (SiH₄) gas is employed for doping. Initially, a trapezoidal crystal is formed with the MOCVD method as high as above the window of the ELO mask, and the MOCVD method is changed to the HVPE method immediately before the crystals are combined with each other on the ELO mask. According to Patent Document 4, the growth temperature is preferably set to 950°C to 1050°C.

EPC publication EP 0942459 A1 (hereinafter referred to as Patent Document 5) is substantially the same as Patent Document 4, and proposes an approach for reducing dislocation by using two or three ELO masks. In addition, Japanese Patent No. 3788104 (Japanese Patent Laying-Open No. 2000-044400; hereinafter referred to as Patent Document 6) proposes for the first time a method of manufacturing an n-type GaN substrate by doping GaN with oxygen as the n-type dopant.

In Patent Documents 4 and 5, the silane (SiH₄) gas is employed and the crystal is doped with Si as the n-type dopant. As the silane gas is explosive, it is dangerous to use a large amount of silane gas for growth of the n-type substrate. Patent Document 6 has found that oxygen forms a shallow donor level in the GaN crystal. The GaN crystal grows while maintaining C face when it is grown with the HVPE method by adding water to the raw material gas such as NH₃ or HCl and providing the ELO mask on the GaAs substrate. When oxygen is introduced fronrthe raw material, however, the donor level is formed, n-type carriers are produced, and the n-type crystal is obtained. In addition, an activation ratio is 100% over a wide concentration range. Patent Document 6 discloses for the first time the fact that oxygen is an n-type dopant suitable for a thick crystal such as a substrate.

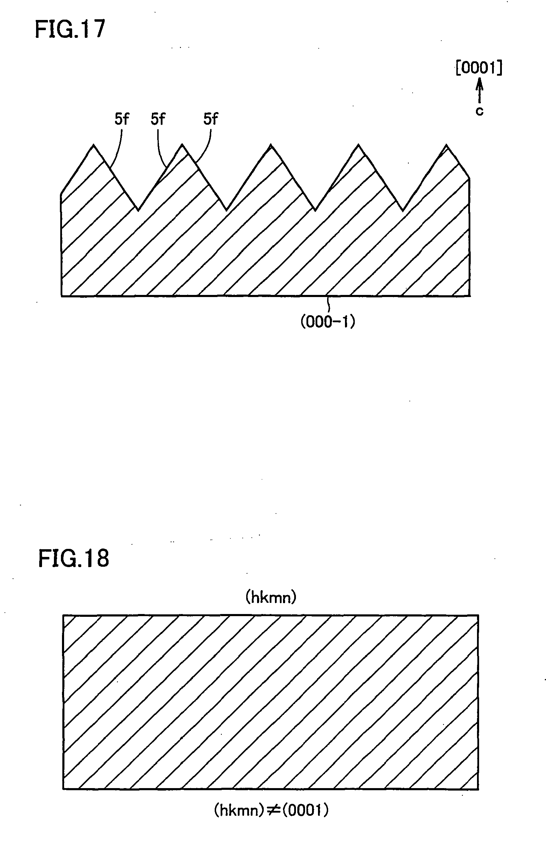

Japanese Patent No. 3826825 (Japanese Patent Laying-Open No. 2002-373864; hereinafter referred to as Patent Document 7) discloses the fact that significant anisotropy is observed when the GaN crystal is doped with oxygen. In other words, Patent Document 7 discloses selectivity that introduction of oxygen through the C face ((0001) face) is less likely but introduction thereof through a face other than the C face is likely. Patent Document 7 proposes a method of introducing oxygen into the crystal through facets 5f that are non-C faces formed at a surface in a large number, although growth being in a direction of a c axis ("0001" direction) on average as shown in Fig. 17, or a method of doping the crystal with oxygen through the non-C face by employing a GaN underlying substrate having a non-C face (hkmn) (≠(0001) face) as shown in Fig. 18. Patent Document 7 discloses for the first time significant anisotropy in oxygen doping.

HVPE growth conditions described in the examples of Patent Document 7 are expressed by (growth temperature Tq, NH₃ partial pressure P_{NH3}, HCl partial pressure P_{HCl}, and group V/group III ratio R_{5/3}) as follows: (1020°C, 20kPa, 1kPa, 20).

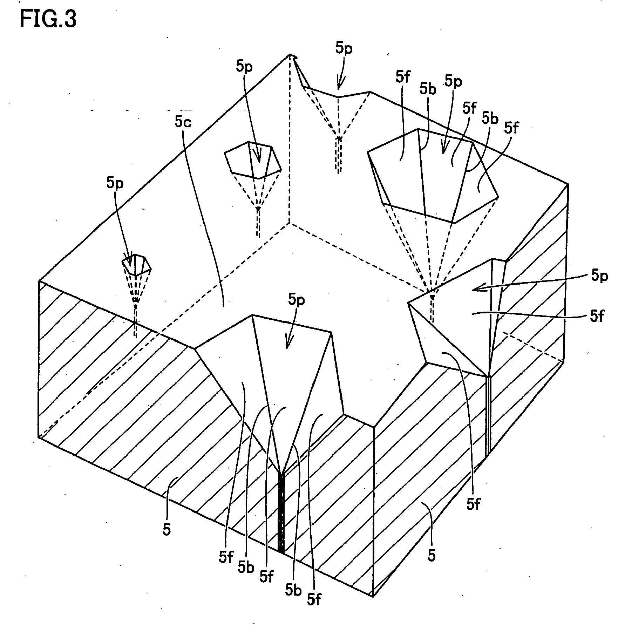

Japanese Patent Laying-Open No. 2001-102307 (hereinafter referred to as Patent Document 8) newly proposes a method of lowering dislocation density that is completely different from the ELO method. According to Patent Document 8, by appropriately controlling growth conditions, a large number of facets 5f and pits 5p formed by facets and having various sizes are positively fabricated as shown in Fig. 3, and facets 5f and pits 5p are maintained until the end of growth without being buried. As the facets are maintained until the end without being buried, this method is called facet growth. Here, though pit 5p is in a shape of a hexagonal or dodecagonal pyramid, the pit in a shape of a hexagonal pyramid is shown here for the sake of brevity.

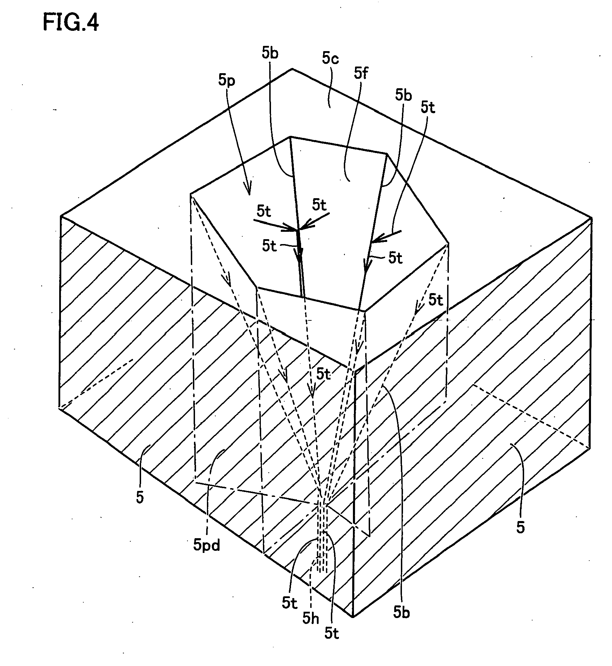

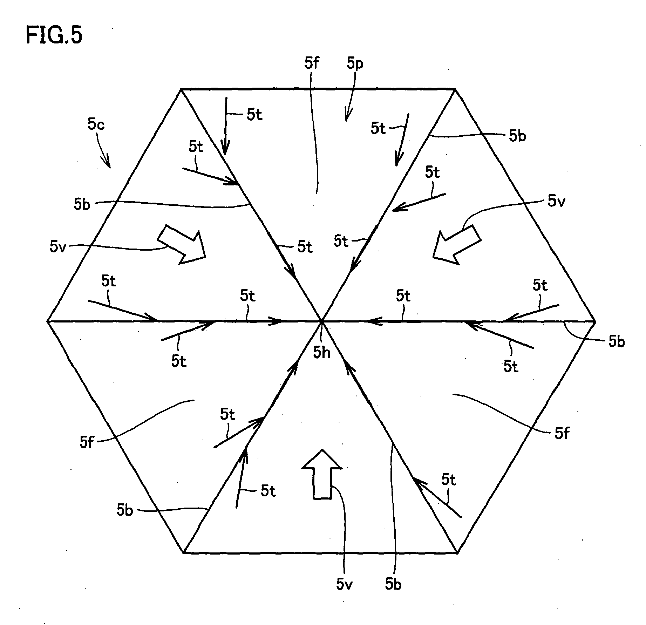

As shown in the perspective view and the plan view of pit p in Figs. 4 and 5 respectively, when the crystal grows with the recessed portion (pit 5p) formed by facets 5f being maintained, the crystal grows in a direction of normal 5v of facet 5f in pit 5p.

As dislocation 5t extends along a direction of growth 5v, dislocation 5t extends in the direction of normal of the facet. Dislocation 5t is drawn to a boundary 5b by allowing facet growth. Dislocations 5t are concentrated under boundary 5b (a surface-like dislocation-concentrated crystal region 5pd).

As facet growth proceeds, dislocations are further concentrated to the bottom of pit 5p. A portion where a large number of dislocations 5t are concentrated (defect concentration in the form of a line: a dislocation-concentrated crystal region 5h) is formed at the bottom of pit 5p. Even though the total dislocation does not much vary, dislocation density in other portions lowers, because dislocations are concentrated in surface-like dislocation-concentrated crystal region 5pd or in dislocation-concentrated crystal region 5h in the form of a line. Unlike the ELO method, this is a completely new method of lowering dislocation density effective from an intermediate stage to the last stage of growth, and this method is referred to as a facet growth method.

The method according to Patent Document 8 is called random facet because it is not known where pit 5p (recessed portion) is formed, and this method is distinguished from subsequent improvement. The resultant crystal has remarkable irregularities in the surface.

Growth conditions described in the examples of Patent Document 8 are expressed by (growth temperature Tq, NH₃ partial pressure P_{NH3}, HCl partial pressure P_{HCl}, and group V/group III ratio R_{5/3}) as follows: (1050°C, 20kPa, 0.5kPa, 40), (1000°C, 30kPa, 2kPa, 15), (1050°C, 20kPa, 0.5kPa, 40), (1020°C, 20kPa, 1kPa, 20), (1000°C, 30kPa, 2kPa, 15), (1000°C, 40kPa, 3kPa, 13), and (980°C, 40kPa, 4kPa, 10).

Patent Document 8 may be referred to as a random facet method, because a position where facet pit 5p (referring to pit 5p formed by facets 5f; to be understood similarly hereinafter) is formed is accidental. According to the method, crystal growth is not locally specific. Therefore, dislocations once concentrated may again be distributed as growth proceeds. As the substrate should carry a device thereon, it would be more convenient if a position where facet pit 5p is formed can be designated in advance. If dislocations can be confined so as to avoid distribution again of the same, dislocation reduction can further be thorough.

According to Japanese Patent No. 3864870 (Japanese Patent Laying-Open No. 2003-165799; hereinafter referred to as Patent Document 9), as shown in Fig. 6, mask 3 where isolated, dotted coating portions (mask 3 portions) are regularly arranged is formed on underlying substrate 1. An exposed portion of underlying substrate 1 (an exposed portion 1e) is much greater than the coating portion (mask 3 portion). A GaN crystal is vapor-deposited on masked underlying substrate 1. As crystal growth is delayed on the coating portion (mask 3 portion), a recessed portion (facet pit 5p) with the coating portion (mask 3 portion) serving as the bottom is formed.

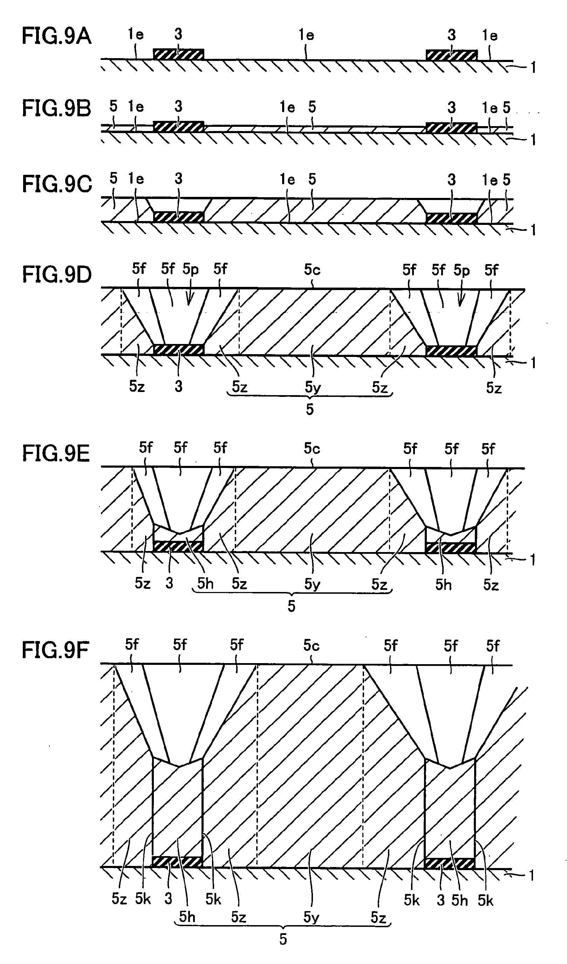

Facet growth of GaN crystal 5 by using a dot-type mask will be described with reference to Figs. 9A to 9F. As shown in Fig. 9A, isolated, dotted coating portions (mask 3 portions) are formed on underlying substrate 1. When a gallium nitride crystal is vapor-deposited, as shown in Fig. 9B, crystal 5 grows only on an exposed portion 1e of underlying substrate 1, not on the coating portion (mask 3 portion). When crystal 5 further grows, as shown in Fig. 9C, crystal 5 is further accumulated on exposed portion 1e. Here, an inclined surface is facet 5f having low Miller indices. When crystal 5 further grows, as shown in Fig. 9D, facet pit 5p in a shape of a hexagonal pyramid or a dodecagonal pyramid with the coating portion (mask 3 portion) serving as the bottom and the inclined surface serving as facet 5f is formed. When crystal 5 further grows, as shown in Fig. 9E, crystal 5 runs also on the coating portion (mask 3 portion), and this portion is dislocation-concentrated crystal region 5h where dislocations are concentrated in high density. A portion under facet 5f is a dislocation-reduced facet growth crystal region 5z. The flat surface is C face 5c. A portion under C face 5c is a dislocation-reduced C face growth crystal region 5y. Here, dislocation-concentrated crystal region 5h, dislocation-reduced C face growth crystal region 5y and dislocation-reduced facet growth crystal region 5z in the GaN crystal can be observed by observing a visible light image of the GaN crystal with a fluorescent microscope. Specifically, in the visible light image obtained by the fluorescent microscope, dislocation-concentrated crystal region 5h is observed as a dark region, dislocation-reduced C face growth crystal region 5y is observed as an intensely bright region (intense light-emitting region), and dislocation-reduced facet growth crystal region 5z is observed as a weakly bright region (weak light-emitting region).

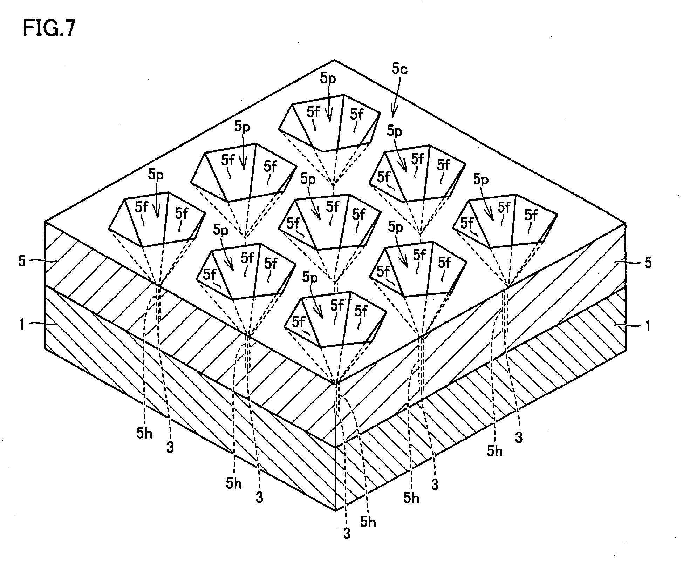

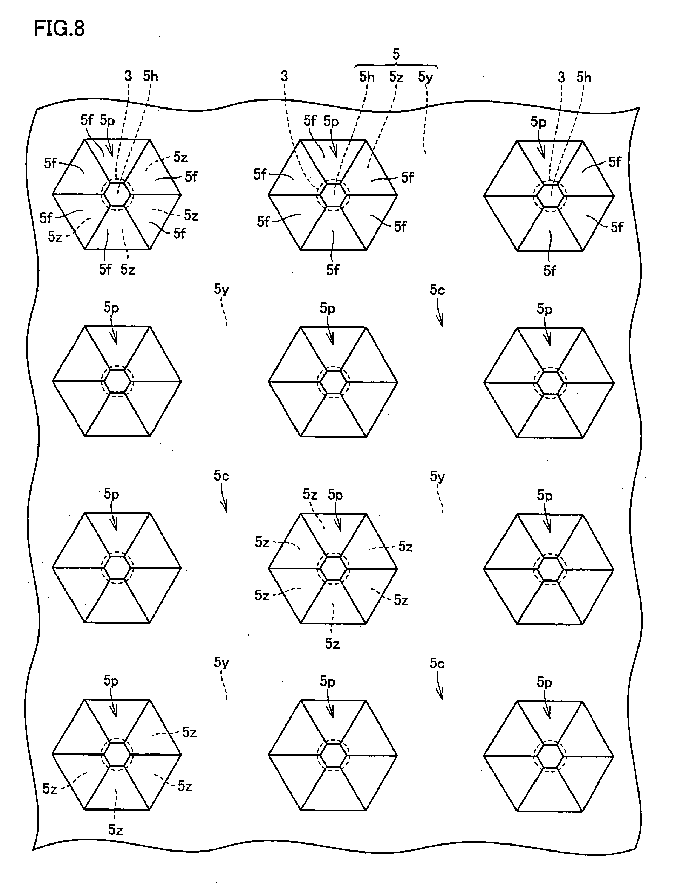

Referring to the perspective view and the plan view of crystal 5 shown in Figs. 7 and 8 respectively, facet pits 5p formed by facets 5f like petals and in an inverted-cone shape are arranged in rows and columns in the surface of GaN crystal 5. A crystal region corresponding to a stem under pit 5p is dislocation-concentrated crystal region 5h where dislocations are concentrated. A portion corresponding to a root under the stem (dislocation-concentrated crystal region 5h) is the coating portion (mask 3 portion). The flat surface is C face 5c. A crystal region that has grown under C face 5c (dislocation-reduced C face growth crystal region 5y) is a low-dislocation-density portion. A crystal region that has grown under facet 5f (dislocation-reduced facet growth crystal region 5z) is also a low-dislocation-density portion. For distinction from others, such an embodiment may be referred to as a dot type, and the method here is provisionally referred to as a dot facet growth method.

As described previously, facet pit 5p serves to concentrate dislocation 5t located on facet 5f to boundary 5b and to further concentrate the same to the pit bottom. The pit bottom (on the coating portion (mask 3 portion)) serves as dislocation-concentrated crystal region 5h where dislocations are concentrated. Dislocations once concentrated are not distributed again. Therefore, dislocation-concentrated crystal region 5h is also referred to as a "closed dislocation-concentrated crystal region." Other portions are dislocation-reduced facet growth crystal region 5z (formed under the facet) and dislocation-reduced C face growth crystal region 5y (formed under the C face) where dislocations have been reduced. Both of dislocation-reduced facet growth crystal region 5z and dislocation-reduced C face growth crystal region 5y thus obtained achieve reduced dislocations. Therefore, dislocation-reduced facet growth crystal region 5z and dislocation-reduced C face growth crystal region 5y are also collectively referred to as a dislocation-reduced crystal region 5yz.

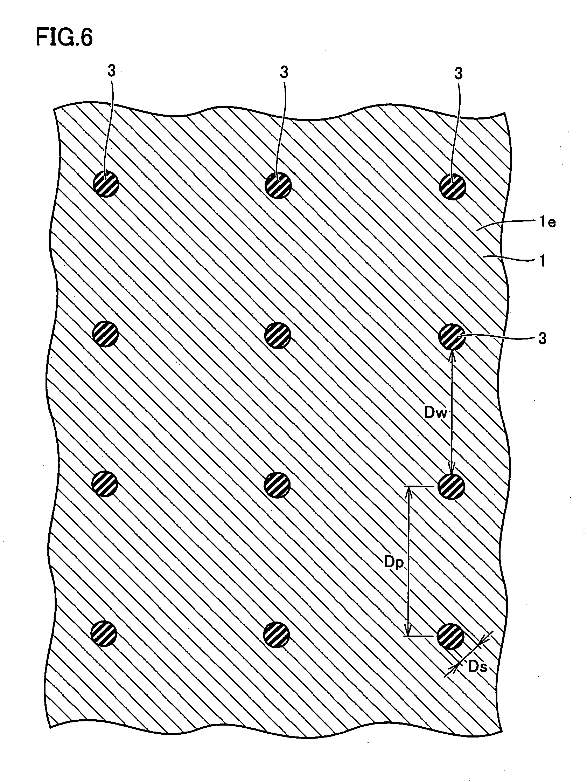

Patent Document 9 has introduced for the first time the concept of dislocation-concentrated crystal region 5h, dislocation-reduced facet growth crystal region 5z, and dislocation-reduced C face growth crystal region 5y. Although the mask is employed, the mask does not include small windows at fine pitches as in the ELO mask. Instead, the dotted (annular or rectangular) coating portions (mask 3 portions) having a considerably large size are formed in large exposed portion 1e of underlying substrate 1 (Fig. 6).

The ELO mask shown in Fig. 1 has exposed portions 1e (window 3w) of underlying substrate 1 smaller in area than the coating portion (mask 3 portion), exposed portions 1e being small in size (diameter from 1 to 2µm) and provided at small pitches (2µm to 6µm).

In contrast to the ELO mask, mask 3 serving as the base for facet pit 5p according to Patent Document 9 has exposed portion 1e of underlying substrate 1 greater in area than the coating portion (mask 3 portion). The coating portion (mask 3 portion) has a considerably large diameter (diameter from 20µm to 100µm). The top of the coating portion (mask 3 portion) serves as the facet pit bottom. Facet pit 5p concentrates and traps dislocations at its bottom and does not allow distribution of dislocations again. Dislocation-concentrated crystal region 5h having high dislocation density is formed on mask 3, and dislocation-reduced facet growth crystal region 5z and dislocation-reduced C face growth crystal region 5y having low dislocation density are formed around the same. Dislocation-reduced facet growth crystal region 5z and dislocation-reduced C face growth crystal region 5y having low dislocation density are formed on exposed portion 1e of underlying substrate 1 not coated with the mask. Dislocation-reduced facet growth crystal region 5z is formed directly under facet 5f, and dislocation-reduced C face growth crystal region 5y is formed directly under a C face growth portion. Both of dislocation-reduced facet growth crystal region 5z and dislocation-reduced C face growth crystal region 5y are monocrystalline and low in dislocation density. A concentric structure around the dotted mask, that is, the structure of dislocation-concentrated crystal region 5h/dislocation-reduced facet growth crystal region 5z/dislocation-reduced C face growth crystal region 5y, is formed. In the ELO, dislocation-concentrated crystal region 5h of high dislocation density is formed on exposed portion 1e (window 3w in mask 3) of underlying substrate 1, and dislocation-reduced facet growth crystal region 5z and dislocation-reduced C face growth crystal region 5y having low dislocation density are formed on the coating portion (mask 3 portion). Namely, relation is totally opposite.

Growth conditions in the examples of Patent Document 9 are expressed by (growth temperature Tq, NH₃ partial pressure P_{NH3}, HCl partial pressure P_{HCl}, and group V/group III ratio R_{5/3}) as follows: (1050°C, 30kPa, 2kPa, 15), (1030°C, 30kPa, 2.5kPa, 12), (1010°C, 20kPa, 2.5kPa, 8), (1030°C, 25kPa, 2.5kPa, 10), (1050°C, 30kPa, 2.5kPa, 12), (1030°C, 25kPa, 2kPa, 12.5), and (1030°C, 25kPa, 2kPa, 12.5).

According to Patent Document 9, mask 3 includes regularly distributed, isolated spots (dots). Therefore, dislocation-concentrated crystal region 5h is formed on the dot, and dislocation-reduced facet growth crystal region 5z and dislocation-reduced C face growth crystal region 5y are formed around the same. As a device such as a semiconductor laser and a light-emitting diode is formed on dislocation-reduced facet growth crystal region 5z and dislocation-reduced C face growth crystal region 5y, distribution of dislocation-concentrated crystal regions 5h may be disadvantageous.

Then, according to Japanese Patent No. 3801125 (Japanese Patent Laying-Open No. 2003-183100; hereinafter referred to as Patent Document 10), as shown in Fig. 10, mask 3 having parallel-striped coating portions (mask 3 portions) at regular intervals is formed on underlying substrate 1, and a GaN crystal is grown thereon with the facet being formed. The sum of a width Ds of the coating portion (mask 3 portion) of mask 3 and a width Dw of exposed portion 1e of underlying substrate 1 is a pitch Dp (Dp = Ds+Dw). Ds is much smaller than Dw. The GaN crystal grows on underlying substrate 1 through vapor deposition.

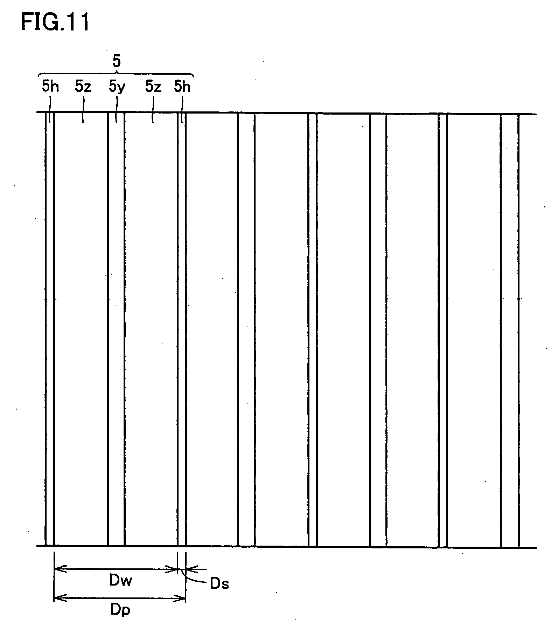

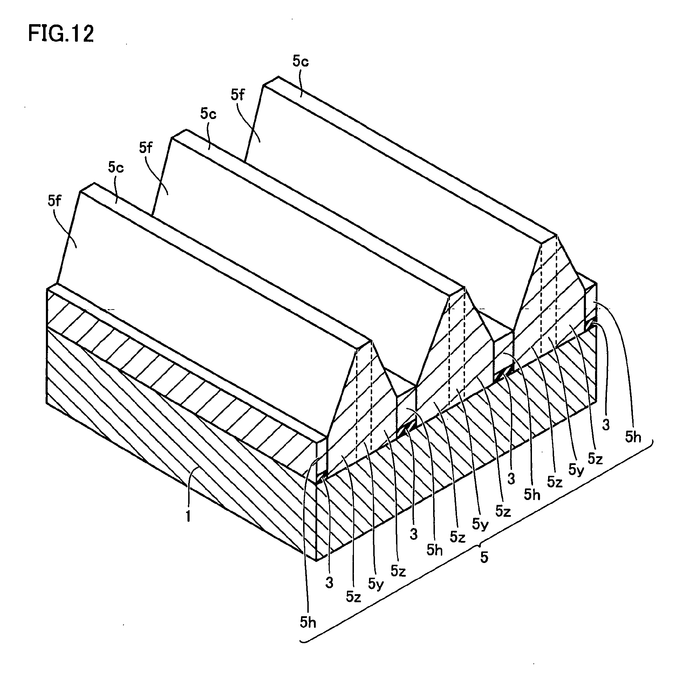

Referring to the plan view and the perspective view of crystal 5 shown in Figs. 11 and 12 respectively, a large number of parallel, peak-and-valley-type crystals having a flat top surface are obtained as GaN crystal 5. Dislocation-concentrated crystal region 5h parallel to each other is formed on the coating portion (mask 3 portion), and dislocation-reduced facet growth crystal region 5z and dislocation-reduced C face growth crystal region 5y parallel to each other are formed on the exposed portion of underlying substrate 1. A region formed on the parallel mask where dislocations are concentrated is referred to as dislocation-concentrated crystal region 5h. A crystal region that continuously grows under facet 5f adjacent to such dislocation-concentrated crystal region 5h is referred to as dislocation-reduced facet growth crystal region 5z. Dislocation-reduced C face growth crystal region 5y may or may not be formed between adjacent dislocation-reduced facet growth crystal regions 5z, 5z.

According to Patent Document 9, dislocations once concentrated in dislocation-concentrated crystal region 5h formed on the mask in the shape of the isolated spot are not distributed again. In other words, dislocation-concentrated crystal region 5h formed on the mask in the shape of the isolated spot is closed. Similarly, dislocations once concentrated in dislocation-concentrated crystal region 5h formed on the striped mask are not distributed again. In other words, dislocation-concentrated crystal region 5h formed on the striped mask is also closed. Dislocation-reduced facet growth crystal region 5z grows between dislocation-concentrated crystal regions 5h. Dislocation-reduced C face growth crystal region 5y may or may not be formed. Dislocation-reduced C face growth crystal region 5y is a crystal region that grows under the C face.

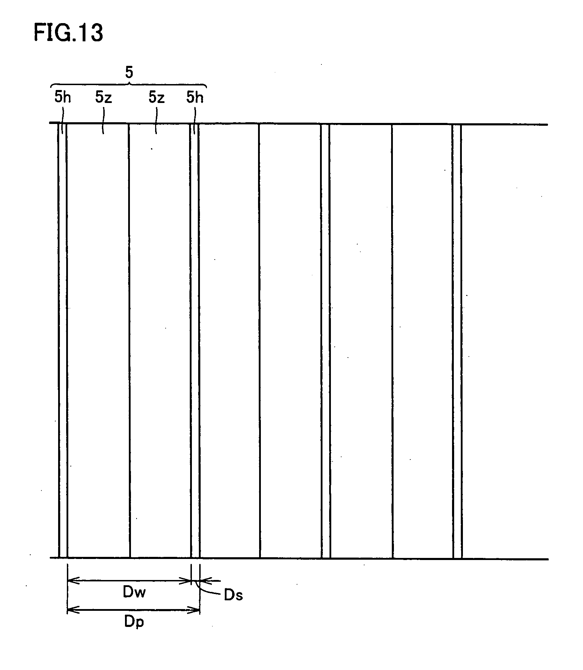

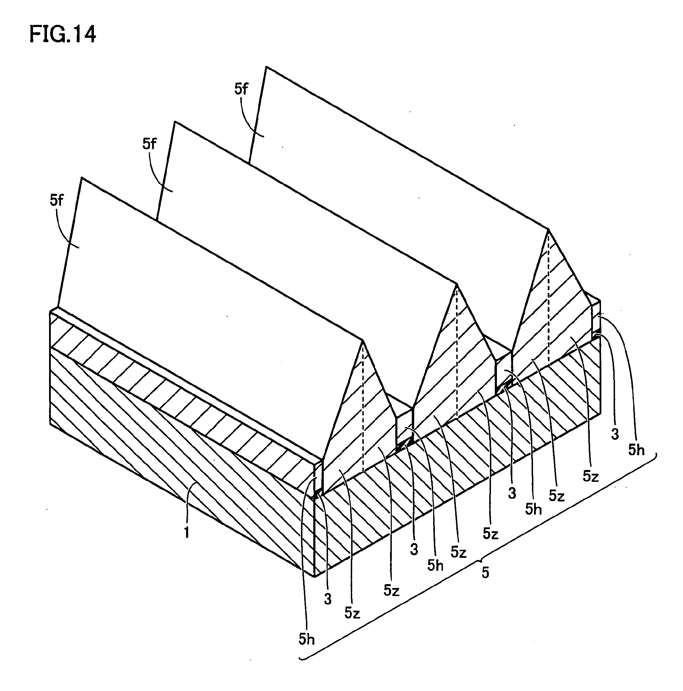

Depending on a growth method, dislocation-reduced C face growth crystal region 5y may be absent. Referring to the plan view and the perspective view of crystal 5 shown in Figs. 13 and 14 respectively, a peak-and-valley-type crystal having a sharp ridge may be obtained as GaN crystal 5. Dislocation-concentrated crystal region 5h parallel to each other is formed on the coating portion (mask 3 portion). This portion is a valley. On the exposed portion of underlying substrate 1 adjacent thereto, dislocation-reduced facet growth crystal region 5z parallel to each other is formed. Peak formed by facets 5f, 5f forming a chevron shape sharpened, and there is no C face 5c portion. Dislocation-reduced C face growth crystal region 5y is absent. In other words, resultant GaN crystal 5 has a structure of ---dislocation-reduced facet growth crystal region 5z/dislocation-concentrated crystal region 5h/dislocation-reduced facet growth crystal region 5z/dislocation-concentrated crystal region 5h---.

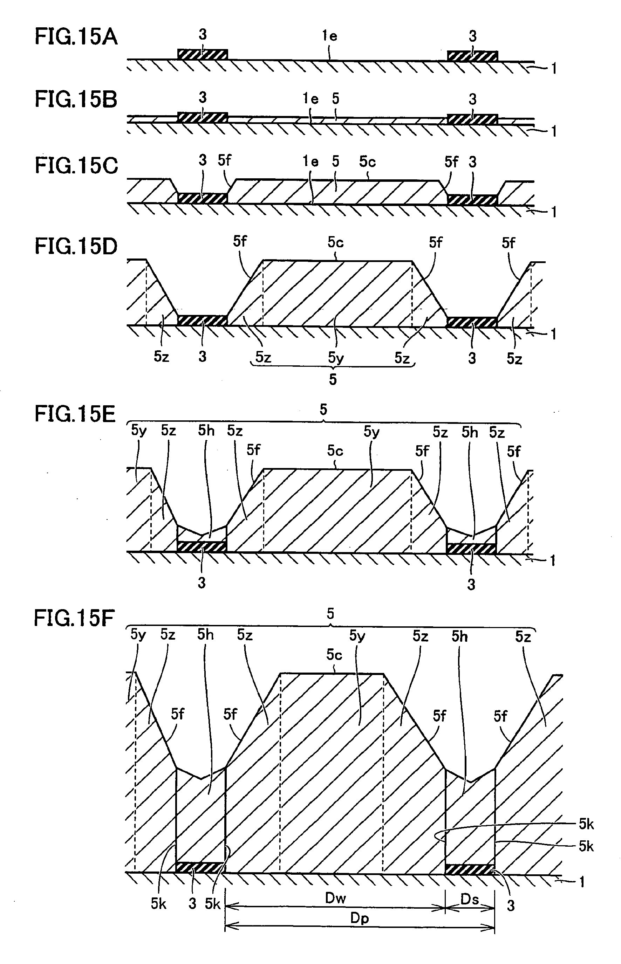

A stripe-type facet growth method will be described with reference to Figs. 15A to 15F. As shown in Fig. 15A, a plurality of parallel striped coating portions (mask 3 portions) are formed on underlying substrate 1. When a gallium nitride crystal is vapor-deposited on underlying substrate 1, as shown in Fig. 15B, crystal 5 grows only on exposed portion 1e of underlying substrate 1, not on the coating portion (mask 3 portion). When crystal 5 further grows, as shown in Fig. 15C, crystal 5 is accumulated on exposed portion 1e of underlying substrate 1. Here, an inclined surface is facet 5f having low Miller indices. Crystal 5 is in a parallel island shape sectioned by the coating portion. When crystal 5 further grows, as shown in Fig. 15D, a V-shaped groove having the coating portion (mask 3 portion) as the bottom and formed by parallel inclined surfaces inclined in a direction opposite to each other is formed in parallel. The opposing inclined surfaces are formed by facets 5f, 5f forming the same angle but opposite in the direction of inclination. The flat surface of crystal 5 between adjacent masks 3, 3 is C face 5c.

When crystal-5 further grows, as shown in Fig. 15E, crystal 5 runs also on the coating portion (mask 3 portion). This portion is dislocation-concentrated crystal region 5h where dislocations are concentrated in high density. When crystal 5 further grows, as shown in Fig. 15F, dislocation-concentrated crystal region 5h on mask 3 extends upward with its width Ds being substantially maintained. Facet 5f, 5f becomes greater. A portion directly under facet 5f, 5f is dislocation-reduced facet growth crystal region 5z. A grain boundary 5k is present between dislocation-concentrated crystal region 5h and dislocation-reduced facet growth crystal region 5z. Grain boundary 5k confines dislocations in dislocation-concentrated crystal region 5h.

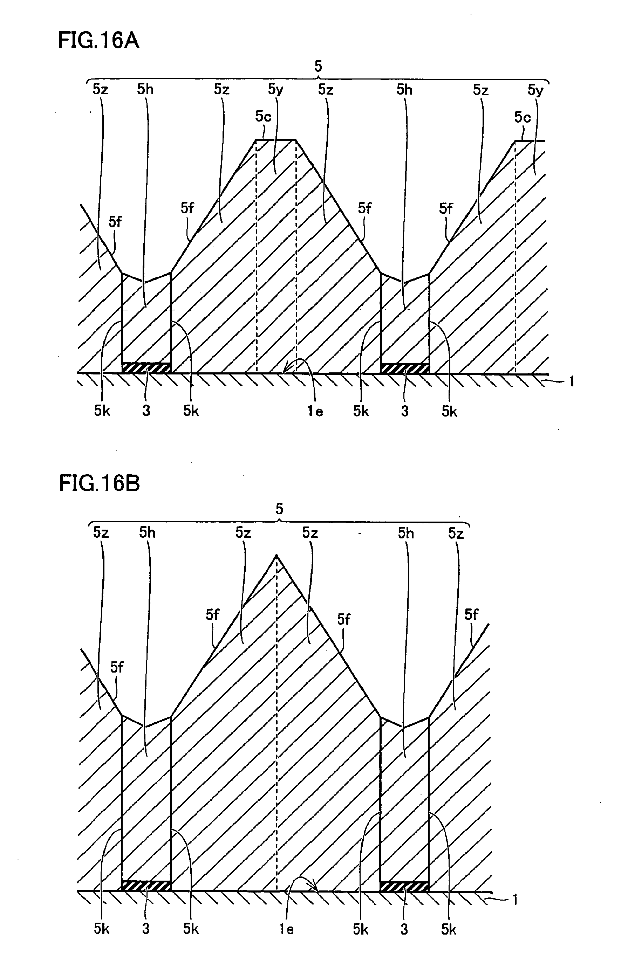

The flat surface of crystal 5 located above a portion between adjacent masks 3, 3 is C face 5c. A portion under C face 5c is dislocation-reduced C face growth crystal region 5y. C face 5c becomes gradually narrower. A pitch between crystals 5 having a striped structure is equal to pitch Dp between masks 3. Mask pitch Dp is the sum of width Ds of mask 3 and width Dw of exposed portion 1e of underlying substrate 1 (Dp = Ds+Dw). When crystal 5 further grows, as shown in Fig. 16A, parallel crystals 5 like a mountain chain with dislocation-concentrated crystal region 5h serving as the foot and C face 5c serving as the ridge grow. C face 5c portion corresponding to the peak is narrow. Dislocation-reduced facet growth crystal region 5z is formed directly under facet 5f and C face growth crystal region 5y is formed directly under the C face.

When crystal 5 further grows, the crystal may grow upward with the shape as shown in Fig. 16A being maintained. Alternatively, as shown in Fig. 16B, the crystal may grow like a parallel mountain chain having a sharper peak. In such a case, neither C face nor C face growth crystal region 5y is present.

Crystal 5 obtained according to Patent Document 10 has a striped structure of --- dislocation-reduced facet growth crystal region 5z/dislocation-concentrated crystal region 5h/dislocation-reduced facet growth crystal region 5z/dislocation-reduced C face growth crystal region 5y/dislocation-reduced facet growth crystal region 5z/dislocation-concentrated crystal region 5h/dislocation-reduced facet growth crystal region-5z/dislocafion-reduced C face growth crystal region 5y/dislocation-redfced facet growth crystal region 5z/dislocation-concentrated crystal region 5h---, or a striped structure of ---dislocation-reduced facet growth crystal region 5z/dislocation-concentrated crystal region 5h/dislocation-reduced facet growth crystal region 5z/dislocation-concentrated crystal region 5h/dislocation-reduced facet growth crystal region 5z/dislocation-concentrated crystal region 5h---. As dislocations are concentrated in dislocation-concentrated crystal region 5h, dislocation-reduced facet growth crystal region 5z and dislocation-reduced C face growth crystal region 5y are monocrystalline and low in dislocation density.

According to the method of Patent Document 10, as the striped mask in parallel to each other is formed and striped dislocation-concentrated crystal region 5h in parallel to each other is formed, the method may be referred to as a stripe type facet growth method. According to the crystal obtained with such a method, as dislocation-reduced facet growth crystal region 5z is linearly formed, a device such as a semiconductor laser and a light-emitting diode is readily formed.

The facet growth method is completely different from the ELO method. They are different from each other also in a shape of the mask, a dimension, a function, and the like. The ELO mask in which windows are distributed in a staggered manner is different from the striped mask in the shape and the size, and they are clearly distinguished from each other. Width Ds of the striped mask is in a range from approximately 20µm to 300µm and pitch Dp thereof is in a range from approximately 100µm to 2000µm. For example, width Ds of the striped mask is set to 50µm and pitch Dp thereof is set to 500µm.

According to the facet growth method using a dot type or a stripe type mask, as dislocations are concentrated in dislocation-concentrated crystal region 5h on the mask and enclosed by grain boundary 5k, dislocations are not distributed again. Dislocation-reduced facet growth crystal region 5z adjacent to dislocation-concentrated crystal region 5h and dislocation-reduced C face growth crystal region 5y adjacent to dislocation reduced facet growth crystal region 5z are low in dislocation density and monocrystalline. This dislocation-reduced crystal region should only be used as a portion of a device through which a current flows.

As the GaN crystal has a cleavage plane in a {1-100} direction, a laser resonator mirror can be formed with natural cleavage. As doping with oxygen is performed to attain an n-type crystal, the current flows and an n electrode can be formed at the bottom surface. In this regard, the GaN crystal is superior to the sapphire substrate.

The ELO has a small exposed portion of the underlying substrate, and the crystal grown thereon has high dislocation density. Meanwhile, the ELO has a large coating portion (mask portion), and a portion on the coating portion is low in dislocation density. In contrast, according to the stripe type facet method, the exposed portion of the underlying substrate is large and the crystal grown thereon is low in dislocation density, while the coating portion (mask portion) is small and the portion on the coating portion has high-density dislocation.

Growth conditions in the examples of Patent Document 10 are expressed by (growth temperature Tq, NH₃ partial pressure P_{NH3}, HCl partial pressure P_{HCl}, and group V/group III ratio R_{5/3}) as follows: (1050°C, 30kPa, 2kPa, 15), (1030°C, 30kPa, 2.5kPa, 12), (1050°C, 30kPa, 2kPa, 15), (1010°C, 20kPa, 2.5kPa, 8), (1030°C, 25kPa, 2kPa, 12.5), and (1030°C, 25kPa, 2.5kPa, 10).

Japanese Patent Laying-Open No. 2005-306723 (hereinafter, referred to as Patent Document 11) proposes a method of growing an iron-doped GaN crystal on a sapphire (0001) substrate with the MOCVD method by using H₂, TMG, and ammonia as a raw material gas and using (C₅H₅)₂Fe as a dopant, or with the HVPE method by using H₂, HCl, a Ga melt, and ammonia as a raw material and using (C₅H₅)₂Fe as a dopant, to obtain an iron-doped GaN substrate.

Growth conditions in the examples (MOCVD method) of Patent Document 11 are expressed by (growth temperature Tq, NH₃ partial pressure P_{NH3}, TMG partial pressure P_{TMG}, and group V/group III ratio R_{5/3}) as follows: (1000°C, 15kPa, 0.3kPa, 50).

Growth conditions in the examples (HVPE method) of Patent Document 11 are expressed by (growth temperature Tq, NH₃ partial pressure P_{NH3}, HCl partial pressure P_{HCl}, and group V/group III ratio R_{5/3}) as follows: (1000°C, 15kPa, 0.3kPa, 50).

### SUMMARY OF THE INVENTION

The n-type GaN substrate to be used for a substrate for a blue light-emitting diode and a semiconductor laser has been discussed so far. An attempt to fabricate also an AlInGaN substrate containing a small amount of Al or In has been made, however, such a substrate is for applications of a substrate for a light-emitting element. Such a substrate is of n type and has high conductivity, and a high-density current can be fed thereto. Silicon (Si) or oxygen (O) may be employed as a dopant.

On the other hand, the present invention is directed to a semi-insulating (SI) GaN substrate crystal instead of an n-type crystal. Namely, the present invention is directed not to an n substrate for a light-emitting element but to an SI substrate for applications of an FET and the like.

In the case of a light-emitting element, as a high-density current is fed to the substrate, deterioration may develop from dislocation.

A semi-insulating GaN substrate (SI-GaN substrate) for a lateral electronic device should have withstand voltage property and high resistance sufficient to withstand a high voltage and a large current. High dislocation density of the substrate causes a leakage current, which is not preferable. As a large number of GaN, InGaN and AlGaN thin films having a regular lattice structure are layered on the substrate, fewer dislocations are preferred. For a semi-insulating GaN substrate, a substrate high in insulation, less in warpage, low in dislocation density, and less likely to experience cracking is strongly desired.

The GaN substrates according to the conventional art (Patent Documents 1 to 10) all have low resistivity. The GaN substrate according to Patent Document 1 has the resistivity from 0.005 to 0.08Ωcm, the GaN substrate according to Patent Document 2 has the resistivity from 0.0035 to 0.0083Ωcm, and the GaN substrate according to Patent Document 3 has the resistivity from 0.01 to 0.017Ωcm. As these documents do not describe doping with an n-type dopant, it is assumed that group V holes formed the donor level or doping with an n-type dopant element contained in a raw material gas was performed.

Patent Document 4 does not specifically describe the resistivity. In Patent Document 4, Si is intended as a dopant and an attempt to fabricate a low-resistance n-type GaN substrate is made. Therefore, it is estimated that the resistivity is further lower than in Patent Documents 1 to 3. In view of such descriptions, the upper limit of the specific resistance of the conventional GaN crystal seems to be around 0.08Ωcm.

Such a substrate having a low resistance is not suitable for a semi-insulating substrate to serve as a substrate for a lateral electronic device. To serve as a semi-insulating group III-V nitride substrate, the substrate desirably has the specific resistance not smaller than 10⁵Ωcm. Depending on purposes, the specific resistance not smaller than 10⁶Ωcm or not smaller than 10⁷Ωcm may also be required.

According to the conventional technique for manufacturing a GaN crystal, such a high-resistance crystal cannot be fabricated. What should be done to fabricate such a crystal? The group V holes have a function as donors. In order to prevent generation of group V holes, supply of a group V raw material should be increased. As described already, in the MOCVD method, group V/group III ratio R_{5/3} is set to 1000 to 2000, and if group V/group III ratio R_{5/3} is further raised, more waste of the raw material is caused. In HVPE, group V/group III ratio R_{5/3} is set to approximately 12 to 50 in many cases. Though a ratio of the group V raw material can further be raised, it leads to loss of the raw material, which may not be preferable.

By using a high-purity raw material so as to avoid impurities, a gallium nitride crystal of higher resistance could be fabricated. Nevertheless, the crystal spontaneously becomes n-type and a semi-insulating property sufficient for a lateral electronic device cannot be obtained.

Alternatively, migration of n-type carriers may be suppressed by adding other elements. According to Patent Document 11, an iron-doped GaN crystal has a semi-insulating property. As the vapor deposition method is employed, a gaseous iron compound should be supplied. According to Patent Document 11, a gallium nitride crystal is fabricated on a sapphire substrate with the MOCVD method by using bis(cyclopentadienyl)iron as a dopant. According to Patent Document 11, the iron-doped GaN crystal grows on the sapphire substrate without using a mask.

It is a new concept that iron can raise the resistivity of the GaN crystal. It was found from Patent Document 11 that doping with iron is effective for fabricating semi-insulating GaN. In addition, for a substrate for an electric element such as an FET, less warpage and a low crack generation ratio are also important. Patent Document 11 is silent about generation of crack or fracture.

A method of manufacturing a semi-insulating nitride semiconductor substrate according to the present invention includes the steps of: forming on an underlying substrate, a mask in which dotted or striped coating portions having a width or a diameter Ds from 10µm to 100µm are arranged at an interval Dw from 250µm to 2000µm; growing a nitride semiconductor crystal on the underlying substrate with an HVPE method at a growth temperature from 1040°C to 1150°C by supplying a group III raw material gas and a group V raw material gas of which group V/group III ratio R_{5/3} is set to 1 to 10 and a gas containing iron; and removing the underlying substrate, to thereby obtain a free-standing semi-insulating nitride semiconductor substrate having a specific resistance not smaller than 1×10⁵Ωcm and a thickness not smaller than 100µm. Here, the growth temperature refers to a temperature of an underlying substrate (substrate temperature) used for crystal growth.

A (111) face GaAs wafer, a sapphire wafer, an SiC wafer, a GaN wafer, and the like may be used as an underlying substrate.

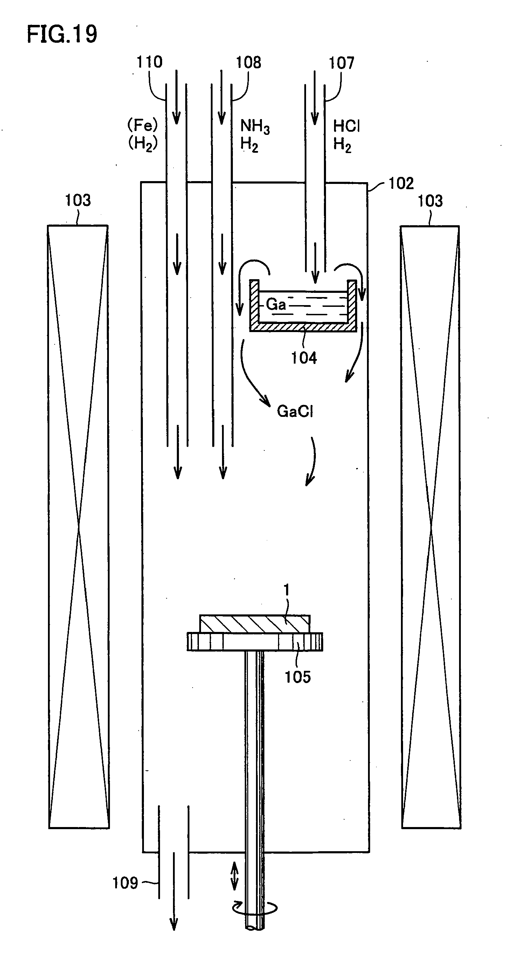

Fig. 19 shows a schematic vertical cross-sectional view of an HVPE furnace. A heater 103 is provided outside a vertically long reactor 102. Heater 103 extends vertically and it is divided into several sections, so that arbitrary temperature distribution can be created in a vertical direction. Reactor 102 has a hot wall. A Ga reservoir 104 containing a Ga melt is provided in an upper-intermediate portion of reactor 102. A susceptor 105 supported by a rotation shaft freely rotating and moving in a vertical direction is provided in a lower portion of reactor 102. Underlying substrate 1 is placed on susceptor 105. A first raw material gas supply pipe 107 supplies a gas of hydrogen (H₂) and hydrochloric acid (HCl) to Ga reservoir 104. As a result of reaction of HCl and Ga, a GaCl gas is created and this gas moves downward. A second raw material gas supply pipe 108 feeds a gas of hydrogen (H₂) and ammonia (NH₃) to above underlying substrate 1. As a result of reaction of GaCl and NH₃, GaN is generated and a GaN crystal grows on underlying substrate 1. A third raw material gas supply pipe 110 supplies a gas mixture of a gaseous compound of iron (Fe) and a carrier gas (H₂) into the reactor. The GaN crystal that grows is doped with iron. After the reaction, an exhaust gas and an unreacted gas are exhausted through a gas exhaust pipe 109.

Bis(cyclopentadienyl) (C₅H₅)₂Fe or bis(methylcyclopentadienyl) (CH₃C_{S}H₄)₂Fe is used as the raw material for doping the GaN crystal with iron. As these raw materials are gaseous, they are introduced into the reactor through a gas flow path above in a form of the gas. These raw materials are thermally decomposed and taken into the crystal, or they react with HCl to generate FeCl, FeCl₂, or FeCl₃, which is in turn introduced into the crystal.

Concentration of iron C_{Fe} in the nitride semiconductor substrate thus fabricated is set as follows: 1×10²⁰cm⁻³≥C_{Fe}≥1×10¹⁶cm⁻³. The nitride semiconductor substrate has a resistivity not smaller than 1 × 10⁵Ωcm.

The mask is composed of SiO₂, SiON, SiN, AlN, Al₂O₃, or the like. As to the dimension of the mask, in the case of a striped mask, width Ds of the coating portion (mask 3 portion) is in a range from 10µm to 100µm. Interval Dw between the coating portions (mask 3 portions) is in a range from 250µm to 2000µm. Pitch Dp is in a range from 260µm to 210µm. Here, relation of Dp = Ds+Dw is satisfied.

In the case of a dotted mask, diameter Ds of the coating portion (mask 3 portion) is in a range from 10µm to 100µm. Interval Dw between the coating portions (mask 3 portions) is in a range from 250µm to 2000µm. Pitch Dp is in a range from 260µm to 2100µm. Here, relation of Dp = Ds+Dw is satisfied.

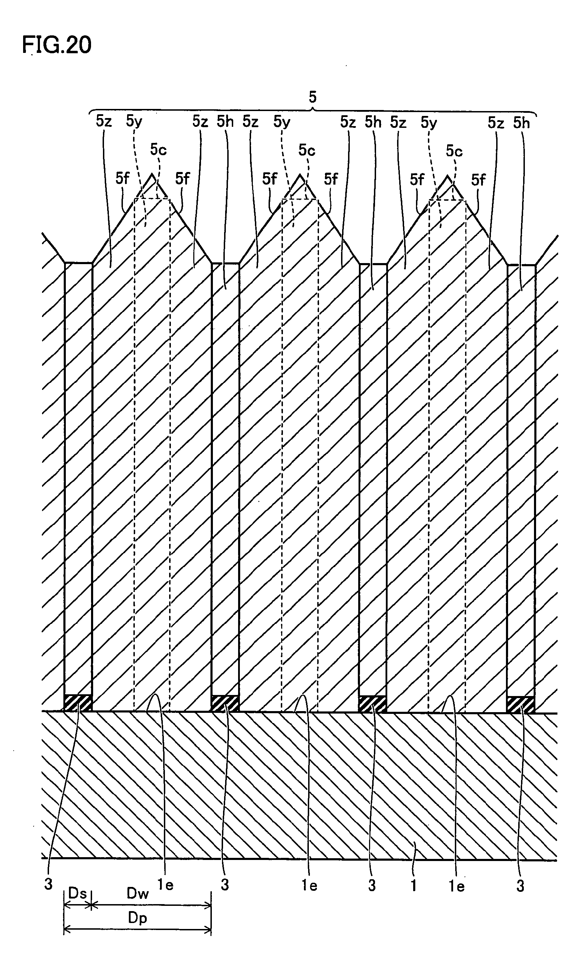

When the substrate temperature is in a range from 1040°C to 1080°C, chevron-shaped crystal 5 (II type) having facet 5f having a bottom on the coating portion (mask 3 portion) and a peak over exposed portion 1e of underlying substrate 1 grows (Fig. 20). In such crystal 5, a portion on mask 3 is dislocation-concentrated crystal region 5h and a portion directly under facet 5f above exposed portion 1e near mask 3 is dislocation-reduced facet growth crystal region 5z.

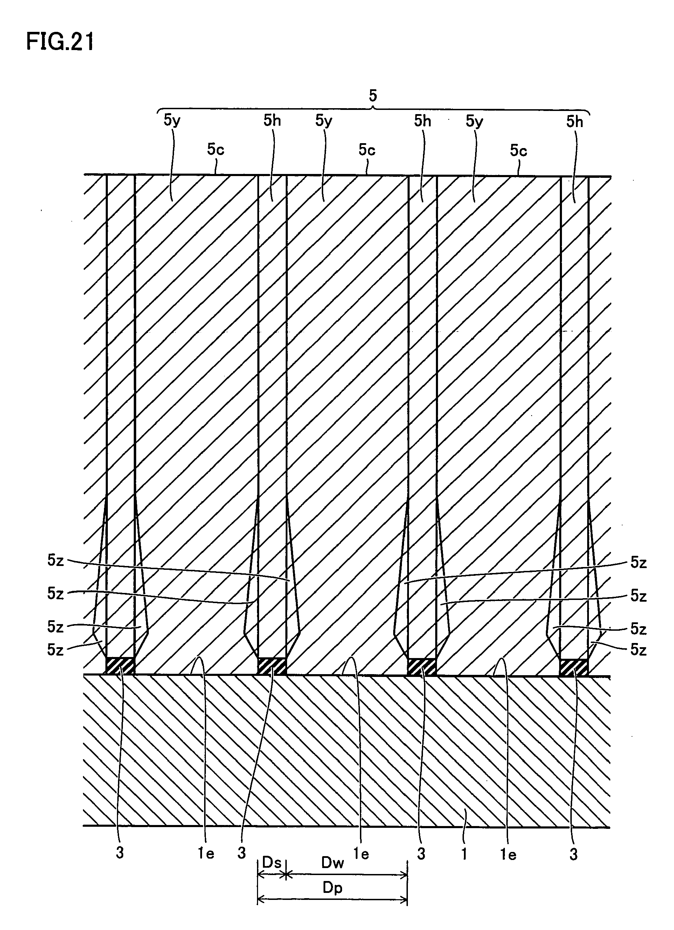

Fig. 20 shows an ideal example in which the surface of the crystal is in the chevron-shape, for the purpose of emphasizing contrast to Fig. 21. Such an ideal example is obtained only when a crystal grows under special conditions with the use of a striped mask. If a dotted mask is used, such an ideal example cannot be obtained due to geometrical restrictions. Whichever of the dotted mask and the striped mask may be used, in many cases, C face 5c (shown with a dashed line) is actually formed in a position intermediate between adjacent masks 3 and dislocation-reduced C face growth crystal region 5y is formed under C face 5c. As the structure includes different regions such as dislocation-concentrated crystal region 5h and dislocation-reduced facet growth crystal region 5z, or dislocation-concentrated crystal region 5h and dislocation-reduced facet growth crystal region 5z and dislocation-reduced C face growth crystal region 5y, strain (tension) caused by the internal stress generated as a result of dislocation reduction in dislocation-reduced facet growth crystal region 5z and dislocation-reduced C face growth crystal region 5y can be alleviated.

II type crystal 5 shown in Fig. 20 has facet 5f on the upper surface, and it tends to absorb much oxygen through facet 5f. Here, oxygen which is an n-type impurity may counteract an effect of doping with iron. Then, concentration of iron should be increased, and an amount of impurities as a whole may increase.

When the substrate is set to a higher temperature from 1080°C to 1150°C, I type crystal 5 having a surface at uniform height grows as shown in Fig. 21. The surface of the crystal is formed as substantially flat C face 5c. Fig. 21 also shows an ideal example for emphasizing contrast to Fig. 20. Actually, a portion on mask 3 may slightly be recessed in many cases, because the portion on mask 3 is dislocation-concentrated crystal region 5h. In a portion on exposed portion 1e of underlying substrate 1, dislocation-reduced facet growth crystal region 5z and dislocation-reduced C face growth crystal region 5y are present in a mixed manner. As different textures are alternately present, stress inside the crystal can be mitigated.

As I type crystal 5 shown in Fig. 21 grows substantially without forming facet 5f, oxygen is not introduced. Therefore, an effect of doping with iron is noticeable and impurity concentration as a whole can be lowered. As an amount of impurity is small, I type crystal 5 is advantageous in that internal stress is small and crack is less likely. Namely, I type is a structure optimal for an iron-doped nitride semiconductor crystal. In order to fabricate the I type crystal, a higher temperature and a lower group V/group III ratio R_{5/3} are advantageous. For example, the substrate is set to a high temperature from 1080°C to 1150°C and group V/group III ratio R_{5/3} is set to 1 to 10. In addition, the substrate temperature from 1090°C to 1150°C and group V/group III ratio R_{5/3} of 1 to 5 can ensure that the I type structure is obtained.

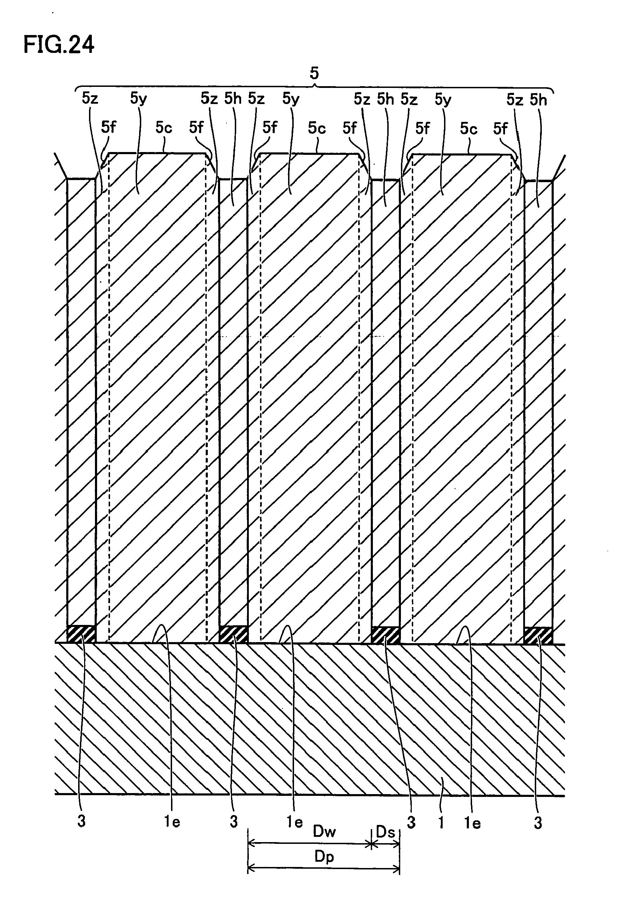

When group V/group III ratio R_{5/3} is set to 1 to 10 and the substrate temperature is set to a temperature around 1080°C (for example, 1070°C to 1090°C), a crystal having a trapezoidal peak representing a mixed type of I type and II type is obtained as shown in Fig. 24.

In three cross-sectional views in Figs. 20, 21 and 24, these three types (structures) of crystals are shown. Here, such phase transition that the cross-sectional shape suddenly changes at a certain growth temperature (substrate temperature) does not occur, but the cross-sectional shape of the crystal continuously changes depending on the growth temperature (substrate temperature) or group V/group III ratio R_{5/3}. When the crystal grows under such conditions as a substrate temperature from 1140 to 1150°C and group V/group III ratio R_{5/3} set to 1 to 3, the I type crystal having a crystal surface in an ideal flat shape as shown in Fig. 21 is obtained. As the growth temperature (substrate temperature) becomes lower and group V/group III ratio R_{5/3} becomes higher in crystal growth, the I type crystal (flat crystal surface) in Fig. 21 makes transition to the II type crystal (chevron-shaped crystal surface) in Fig. 20.

The substrate temperature from 1050°C to 1150°C is rather high for the growth temperature in the vapor deposition method for the nitride semiconductor crystal. What is intended by I type growth is that a high growth temperature (substrate temperature) allows growth of a crystal having a flat surface even with the use of a large mask.

It can be said that group V/group III ratio R_{5/3} from 1 to 10 is the extremely lower limit in the method of vapor-depositing the nitride semiconductor crystal. The concept of the present invention is that an iron-doped nitride semiconductor crystal grows by setting a low group V/group III ratio R_{5/3} and a high growth temperature.

With regard to setting of the growth temperature (substrate temperature) and group V/group III ratio R_{5/3} in the conventional examples, exemplary substrate temperature and group V/group III ratio R_{5/3} were given in the description of Patent Documents 1 to 11.

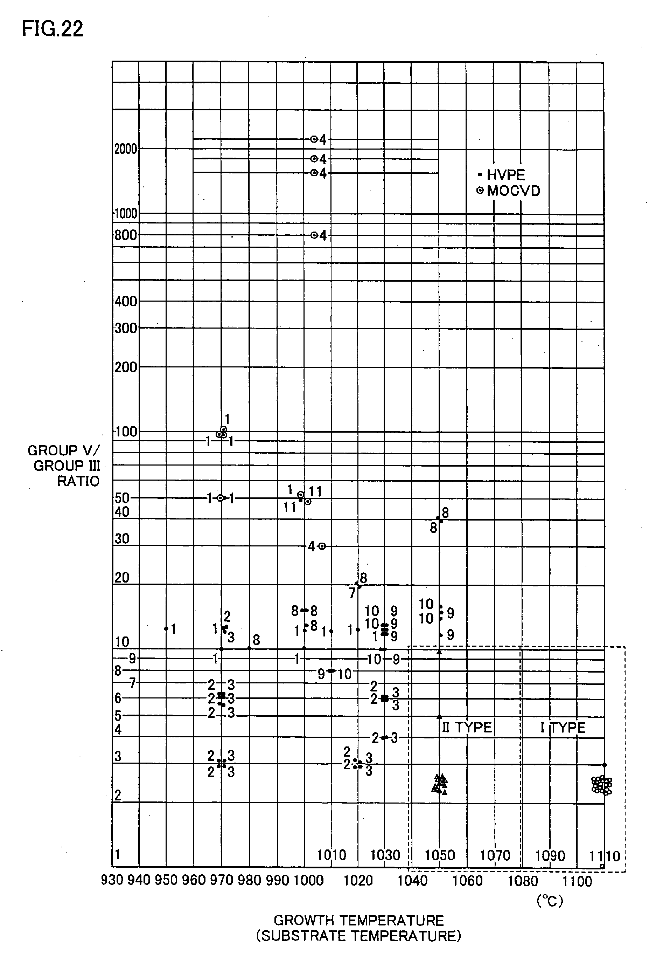

Fig. 22 shows relation between the growth temperature (substrate temperature) and group V/group III ratio R_{5/3}. The abscissa represents the growth temperature (substrate temperature). The ordinate represents group V/group III ratio R_{5/3} in logarithmic scale. A black circle indicates the growth temperature (substrate temperature) and group V/group III ratio R_{5/3} in the HVPE method in the conventional examples. A black circle encircled with a white circle indicates a value in the MOCVD method in the conventional examples. An attached numeric indicates a cited patent document number. One point corresponds to one example.

For example, three black circles encircled with white circle are found at the coordinate of (growth temperature Tq, group V/group III ratio R_{5/3}) of (970°C, 100) and numerics of 1, 1 and 1 are seen. This means that the condition of (970°C, 100) was set in three examples using the MOCVD method in Patent Document 1. With regard to Patent Document 1, nine black circles indicating the examples using HVPE are found between the growth temperatures (substrate temperatures) 950°C and 1020°C.

Patent Document 4 does not show clear examples. In the MOCVD method, as growth temperature Tq is in a range from 960°C to 1050°C and group V/group III ratio R_{5/3} is set to 1000, 800, and the like, the results are expressed with a continuous line.

With regard to the II type crystal in the present invention, a white triangle indicates the growth temperature (substrate temperature) and group V/group III ratio R_{5/3}. There are 14 points where growth temperature Tq is set to 1050°C and group V/group III ratio R_{5/3} is set to 2.5. There is one point where growth temperature Tq is set to 1050°C and group V/group III ratio R_{5/3} is set to 5. There is one point where growth temperature Tq is set to 1050°C and group V/group III ratio R_{5/3} is set to 10.

With regard to the I type crystal in the present invention, a white circle indicates the growth temperature (substrate temperature) and group V/group III ratio R_{5/3}. There are 19 points where growth temperature Tq is set to 1110°C and group V/group III ratio R_{5/3} is set to 2.5. There is one point where growth temperature Tq is set to 1110°C and group V/group III ratio R_{5/3} is set to 3. There is one point where growth temperature Tq is set to 1110°C and group V/group III ratio R_{5/3} is set to 1, and there is one point where growth temperature Tq is set to 1100°C and group V/group III ratio R_{5/3} is set to 2.5.

In Fig. 22, a range of the growth temperature (substrate temperature) and group V/group III ratio R_{5/3} according to the present invention is enclosed with a dashed line. The temperature of 1080°C is suitable for growing a mixed type crystal which is intermediate between the I type and the II type.

In Patent Documents 2 and 3, a mask at a large pitch is not employed. There are 8 examples in which group V/group III ratio R_{5/3} is set to 3. There are 2 examples in which group V/group III ratio R_{5/3} is set to 4. There are 10 examples in which group V/group III ratio R_{5/3} is set to 6. The substrate temperature, however, is set to 970°C, 1020°C, or 1030°C, that is not higher than 1040°C representing the lower limit in the present invention. In Patent Documents 2 and 3, a mask at a large pitch is not employed and doping with iron is not performed. Thus, the present invention is different from Patent Documents 2 and 3 in three points.

Though Patent Document 8 introduced the facet growth method for the first time, a mask at a large pitch is not employed. The present invention is different from Patent Document 8 in three points that the growth temperature is set to 1050°C, group V/group III ratio R_{5/3} is set to 40, and doping with iron is not performed.

In Patent Documents 9 and 10, a mask at a large pitch is employed. When the growth temperature is set to 1030°C or 1050°C, group V/group III ratio R_{5/3} is set to 12, 12.5, or 15. When group V/group III ratio R_{5/3} is set to 8, the growth temperature is set to 1010°C. Doping with iron is not performed here again. The II type crystal according to the present invention is different from Patent Documents 9 and 10 in two points. As the I type crystal according to the present invention has a substantially flat crystal surface, it is different from Patent Documents 9 and 10 in three points.

Patent Document 11 is an only document in which doping with iron is performed. In the MOCVD method, the growth temperature is set to 1000°C and group V/group III ratio R_{5/3} is set to 50. In the HVPE method, the growth temperature is set to 1000°C and group V/group III ratio R_{5/3} is set to 50. A mask is not employed. The present invention is different from this patent document in three points of the growth temperature (substrate temperature), group V/group III ratio R_{5/3}, and use of mask.

As doping with iron is performed, iron counteracts an inherent donor. A semi-insulating nitride semiconductor substrate having a specific resistance not smaller than 10⁷Ωcm can thus be obtained.

As a mask at a large pitch is repeatedly formed on the underlying substrate and the crystal grows thereon, a structure including different textures such as dislocation-concentrated crystal region 5h, dislocation-reduced facet growth crystal region 5z, dislocation-reduced C face growth crystal region 5y, and the like is formed in the crystal. As this structure mitigates the internal stress in the crystal, the crystal with less warpage can be obtained.

As the growth temperature is set to a high temperature from 1040°C to 1150°C and group V/group III ratio R_{5/3} is set to a low value from 1 to 10, the crystal having a considerably flat surface can grow even on the underlying substrate on which a mask at a large pitch is repeatedly formed, so that introduction of oxygen can considerably be prevented. Therefore, it is less likely that the crystal structure is disturbed, and warpage and crack are less likely.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a plan view showing an exemplary mask formed on an underlying substrate.
Figs. 2A to 2G are cross-sectional views showing crystal growth steps using a mask method.
Fig. 3 is a perspective view showing a part of a crystal grown with a facet growth method.
Fig. 4 is a pit perspective view for illustrating concentration of dislocations at a bottom portion of the pit in facet growth.
Fig. 5 is a pit plan view for illustrating concentration of dislocations at the bottom portion of the pit in facet growth.
Fig. 6 is a plan view showing a part of a dot-type mask having a dotted coating portion formed on the underlying substrate for facet growth.
Fig. 7 is a perspective view showing an exemplary GaN crystal grown with a facet being maintained on the underlying substrate provided with the dot-type mask.
Fig. 8 is a plan view showing an exemplary GaN crystal grown with a facet being maintained on the underlying substrate provided with the dot-type mask.
Figs. 9A to 9F are vertical cross-sectional views showing steps of growing a GaN crystal with a facet growth method using a dot-type mask.

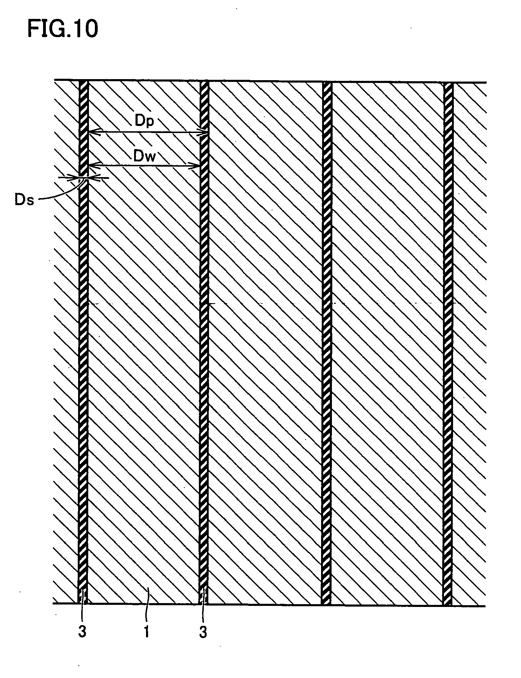

Fig. 10 is a plan view showing a part of a stripe-type mask formed on the underlying substrate for facet growth.
Fig. 11 is a plan view showing an exemplary GaN crystal grown with a facet being maintained on the underlying substrate provided with the stripe-type mask.
Fig. 12 is a perspective view showing an exemplary GaN crystal grown with a facet being maintained on the underlying substrate provided with the stripe-type mask.
Fig. 13 is a plan view showing another exemplary GaN crystal grown with a facet being maintained on the underlying substrate provided with the stripe-type mask.
Fig. 14 is a perspective view showing another exemplary GaN crystal grown with a facet being maintained on the underlying substrate provided with the stripe-type mask.
Figs. 15A to 15F are vertical cross-sectional views showing steps of growing a GaN crystal with a facet growth method using a stripe-type mask.
Figs. 16A and 16B are vertical cross-sectional views showing a further step of growing a GaN crystal with the facet growth method using the stripe-type mask.
Fig. 17 is a cross-sectional view showing an exemplary GaN crystal disclosed in Patent Document 7.
Fig. 18 is a cross-sectional view showing another exemplary GaN crystal disclosed in Patent Document 7.
Fig. 19 is a cross-sectional view showing an exemplary HVPE furnace employed in the present invention.
Fig. 20 is a cross-sectional view showing a II type nitride semiconductor crystal obtained in the present invention.
Fig. 21 is a cross-sectional view showing a I type nitride semiconductor crystal obtained in the present invention.
Fig. 22 is a graph in which relation between a growth temperature and a group V/group III ratio R_{5/3} is plotted in an example using a vapor deposition method according to Patent Documents 1 to 11 and the present invention, the abscissa representing a growth temperature, the ordinate representing group V/group III ratio R_{5/3} in a logarithmic scale, and a numeric provided to each plot representing a patent document number.
Fig. 23 is a graph in which relation between a radius of curvature of warpage and a crack generation ratio is plotted for samples 1 to 45 according to examples and comparative examples of the present invention, the abscissa representing a radius of curvature of warpage, the ordinate representing a crack generation ratio, a numeric provided to each plot representing a sample number, a white circle representing an example of a I type crystal, a white triangle representing an example of a II type crystal, and a white square representing a comparative example, which has not been known.
Fig. 24 is a cross-sectional view showing a mixed-type nitride semiconductor crystal obtained in the present invention.
Fig. 25 is a plan view showing a dimension of a width Ds and an interval Dw of a striped mask formed on the underlying substrate.
Fig. 26 is a plan view showing a dimension of a diameter Ds and an interval Dw of a dotted mask formed on the underlying substrate.

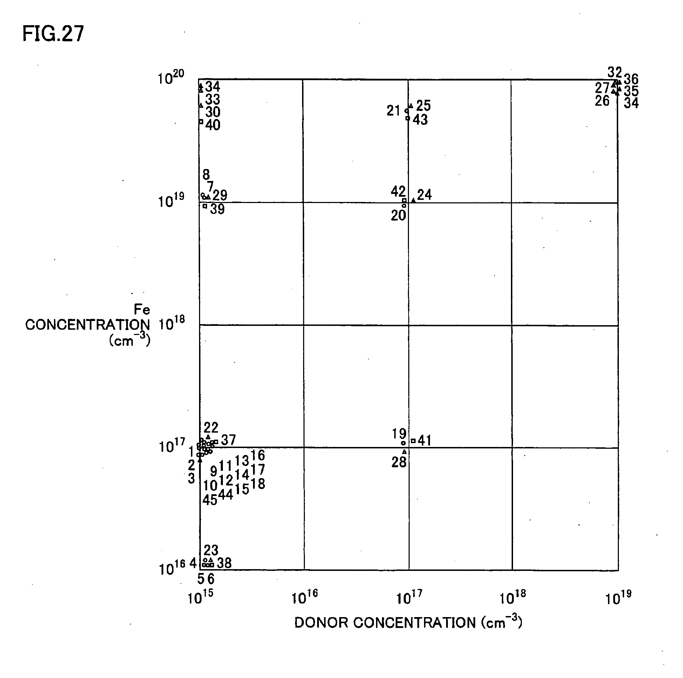

Fig. 27 is a graph in which relation between a donor concentration and an iron concentration is plotted for samples 1 to 45 according to examples and comparative examples of the present invention, the abscissa representing a donor concentration in a logarithmic scale, the ordinate representing an iron concentration in a logarithmic scale, and a numeric provided to each plot representing a sample number, a white circle representing an example of a I type crystal, a white triangle representing an example of a II type crystal, and a white square representing a comparative example, which has not been known.
Fig. 28 is a vertical cross-sectional view showing an epitaxial substrate obtained by growing a GaN thin film on a semi-insulating GaN substrate.
Fig. 29 is a vertical cross-sectional view showing an HEMT obtained by forming an electrode on the epitaxial substrate obtained by growing the GaN thin film on the semi-insulating GaN substrate.
Fig. 30 is a vertical cross-sectional view showing an epitaxial substrate obtained by growing a GaN thin film on a sapphire substrate.
Fig. 31 is a vertical cross-sectional view showing an HEMT obtained by forming an electrode on the epitaxial substrate obtained by growing the GaN thin film on the sapphire substrate.

### DESCRIPTION OF THE PREFERRED EMBODIMENTS

According to Patent Document 11, the substrate temperature is set to 1000°C and group V/group III ratio R_{5/3} is set to 50 so as to grow an iron-doped GaN crystal on the sapphire substrate. When the iron-doped GaN crystal is directly vapor-deposited on the underlying substrate as in Patent Document 11, foreign iron is introduced and a lattice structure is distorted. If the concentration of the impurity (concentration of iron) is high, great stress is generated and such stress cannot be mitigated. Then, internal strain becomes great and hence crack and warpage become great. Unless the internal stress is mitigated, it is not possible to perform doping with Fe in high concentration while suppressing warpage and crack.

The facet growth method proposed in Patent Documents 8, 9 and 10 has a function to reduce dislocations in a peripheral portion (dislocation-reduced crystal region 5yz, that is, dislocation-reduced facet growth crystal region 5z and dislocation-reduced C face growth crystal region 5y, to be understood similarly hereinafter) by providing a mask having a large exposed portion of the underlying substrate on the underlying substrates and by concentrating dislocations (crystal defects) over mask 3. Namely, reduction in dislocations is intended. In the case of a semi-insulating substrate, in order to withstand a large current and a high voltage, the dislocation density is desirably low. In addition, according to the facet growth method in Patent Documents 8, 9 and 10, different structures, that is, dislocation-concentrated crystal region 5h, dislocation-reduced facet growth crystal region 5z and dislocation-reduced C face growth crystal region 5y, are formed in the crystal, which mitigates the stress. Accordingly, it has also been found that an effect to lessen warpage and suppress crack generation is obtained.

The present invention utilizes the facet growth method also in fabricating an iron-doped GaN crystal. According to one facet growth method, a mask may not be provided as in Patent Document 8. On the other hand, according to another facet growth method, a position where dislocation-concentrated crystal region 5h, dislocation-reduced facet growth crystal region 5z and dislocation-reduced C face growth crystal region 5y are to be formed can be designated in advance by attaching mask 3 to underlying substrate 1 as in Patent Documents 9 and 10.

The structure in which dislocation-concentrated crystal region 5h where dislocations are concentrated and dislocation-reduced facet growth crystal region 5z and dislocation-reduced C face growth crystal region 5y where dislocations are fewer are alternately provided can achieve mitigated internal stress in the crystal. Even though there is strain due to impurity doping, the stress can be diminished.

Therefore, the facet growth method by providing the mask on the underlying substrate is useful for manufacturing the iron-doped GaN crystal doped with an impurity in high concentration.

As crystal growth is delayed at a mask-coated portion and growth preferentially proceeds on the exposed portion of the underlying substrate, a facet is formed and dislocation density is lowered. On the other hand, it has been found that, if a facet is formed, the crystal is doped with more oxygen through the facet as described in Patent Document 7.

As described in Patent Document 6, since oxygen generates n-type carriers, the effect of doping with iron is diminished. If oxygen is taken in, doping with a large amount of iron atoms should be carried out for compensation. Then, oxygen and iron are both contained in the crystal in high concentration.

As neither of oxygen and iron is a component originally present in the GaN crystal, doping thereof in a large amount distorts the lattice structure of the crystal. Addition of oxygen and iron in high concentration lowers regularity of the crystal, which results in higher dislocation density, increase in internal stress, and greater warpage, as well as increase in the crack generation ratio. In order to achieve a semi-insulating property, doping with iron is inevitable, however, oxygen is not necessary. Accordingly, oxygen concentration is desirably minimized. For example, it is necessary to refine the raw material gas as much as possible to remove oxygen and moisture. Nevertheless, it is difficult to completely remove moisture, and some oxygen and moisture remain in the raw material gas.

As described in Patent Document 7, introduction of oxygen through the C face is less likely but oxygen is readily introduced through the facet. Then, in order to decrease introduction of oxygen, it seems favorable not to form a facet but to achieve C face growth.

Prior to Patent Documents 8, 9 and 10, C face growth was carried out. Therefore, it is also possible to return to conventional, normal C face growth as in Patent Documents 1 to 5. Such an approach, however, is the same as in Patent Document 11, and satisfactory results in terms of crack and warpage cannot be obtained.

The facet growth method according to Patent Documents 8, 9 and 10 attains a function not only to reduce dislocations but also to lessen internal stress in the crystal and mitigate warpage. Not only a dislocation reduction effect but also an internal stress reduction effect are demanded. Here, the present inventors have arrived at a conclusion that crystal growth with less warpage and less crack generation is achieved by suppressing facet by employing a mask having an exposed portion of the underlying substrate larger than a mask-coated portion and having a large pitch between coating portions and between exposed portions as in Patent Documents 9 and 10 and by controlling the substrate temperature and group V/group III ratio R_{5/3} in an appropriate range.

For example, what should be done to grow, without forming a facet, a crystal on the substrate on which a parallel mask having a width of 50µm is provided at an interval of 500µm? In order to do so, it has been found that a higher growth temperature should be set and a larger amount of group III raw material (such as Ga) should be supplied.

It has been found that, when the growth temperature (substrate temperature) is set to a high temperature not lower than 1080°C and group V/group III ratio R_{5/3} is set to a low value such as 1 to 10, the crystal grows even on the mask provided at a large pitch with the C face being held. When the growth temperature (substrate temperature) is set to 1090°C or higher and group V/group III ratio R_{5/3} is set to 1 to 5, the crystal seems to more reliably grow with the C face being maintained as shown in Fig. 21. When the substrate temperature is set to 1110°C and group V/group III ratio R_{5/3} is set to 1 to 10, the crystal grows without forming a facet. Then, introduction of oxygen is less likely. Oxygen counteracts the function of doping with iron. Without introduction of oxygen, an effect of doping with iron is strongly exhibited. Accordingly, the nitride semiconductor crystal has a semi-insulating property. As the crystal grows on the mask, a portion different in type such as dislocation-concentrated crystal region 5h, dislocation-reduced facet growth crystal region 5z, or dislocation-reduced C face growth crystal region 5y is generated. Such a portion lowers internal stress, and hence warpage and crack is lessened.

Even though oxygen is introduced, doping with iron in an amount sufficient to counteract the effect of oxygen should only be performed. Even if a large amount of impurity is introduced, it does not give rise to a problem so long as the internal stress is small. As described already, if the structure is such that a portion different in type such as dislocation-concentrated crystal region 5h, dislocation-reduced facet growth crystal region 5z, and dislocation-reduced C face growth crystal region 5y is present in a mixed manner, warpage or crack can be lessened. Accordingly, even if the growth temperature (substrate temperature) is slightly lowered, the stress can be lowered in the presence of the mask structure. The nitride semiconductor crystal is grown on the mask structure at a lower substrate temperature around 1040°C. Then, facet growth rather than C face growth is attained as shown in Fig. 20. Though the crystal grows while forming facet 5f, it seems that introduction of oxygen can be prevented to some extent, provided that group V/group III ratio R_{5/3} is low. In addition, in an initial stage of growth, for facet growth, the substrate temperature and group V/group III ratio R_{5/3} are controlled to be in an appropriate range, in order to lessen dislocations and internal stress in the crystal. Thereafter, for C face growth, the substrate temperature and group V/group III ratio R_{5/3} are controlled to be in an appropriate range, in order to decrease an amount of introduction of oxygen. A high-resistance GaN substrate can thus be fabricated with a small amount of Fe doping.

The crystal having a flat surface after crystal growth as shown in Fig. 21 is called I type, while the crystal having a peak-and-valley-type surface as shown in Fig. 20 is called II type, for distinction.

If group V/group III ratio R_{5/3} is as low as 1 to 10 and the growth temperature (substrate temperature) is in a range from 1040°C to 1070°C, II type crystal 5 (Fig. 20) is formed. The surface of dislocation-concentrated crystal region 5h is located at a lower position, facet 5f is formed in a manner continuous to that surface, and dislocation-reduced facet growth crystal region 5z is formed under facet 5f. This figure shows a cross-sectional view of an extreme example where a striped mask is used and no C face is formed. In the case of the striped mask as well, C face 5c may be located in a position intermediate between adjacent masks 3 and dislocation-reduced C face growth crystal region 5y may be present In the case of the dotted mask, C face 5c is formed without exception and dislocation-reduced C face growth crystal region 5y is present under C face 5c.

If group V/group III ratio R_{5/3} is as low as 1 to 10 and the growth temperature (substrate temperature) is as high as 1090°C to 1150°C, I type crystal 5 (Fig. 21) is formed. The surface is flat, and dislocation-concentrated crystal region 5h is present on the mask and exposed at the surface. In other portions, dislocation-reduced facet growth crystal region 5z and dislocation-reduced C face growth crystal region 5y are both present in a mixed manner.

If the growth temperature (substrate temperature) is set to a temperature intermediate between the growth temperature for the I type crystal and the growth temperature for the II type crystal (1070°C to 1090°C), crystal 5 of the mixed type of I type and II type is obtained. Crystal 5 in a trapezoidal shape as shown in Fig. 24 is formed. Dislocation-concentrated crystal region 5h is formed on the mask. Dislocation-reduced facet growth crystal region 5z and dislocation-reduced C face growth crystal region 5y are formed on exposed portion 1 e of underlying substrate 1.

Quite much about dislocation-concentrated crystal region 5h generated on the mask has been learnt through studies conducted so far. Dislocation-concentrated crystal region 5h may simply be referred to as a core. Dislocation-concentrated crystal region 5h is a region in which dislocations are concentrated.

There are three varieties of dislocation-concentrated crystal regions 5h. One is a polycrystalline type and such dislocation-concentrated crystal region 5h is referred to as a polycrystalline layer, in which a large number of crystal grains different in orientation are present. Another is a single crystal type in which the c axis of dislocation-concentrated crystal region 5h is inclined with respect to that of other portions (dislocation-reduced facet growth crystal region 5z and dislocation-reduced C face growth crystal region 5y). Here, other portions are monocrystalline in which the c axis is oriented upward. Such dislocation-concentrated crystal region 5h is referred to as an inclination layer. Remaining one is a single crystal type in which the c axis is oriented downward, that is, a single crystal type in which the orientation of the crystal axis of dislocation-concentrated crystal region 5h is completely inverted with respect to that of other portions (dislocation-reduced facet growth crystal region 5z and dislocation-reduced C face growth crystal region 5y). Such dislocation-concentrated crystal region 5h is referred to as an inversion layer. The inversion layer is most capable of confining dislocations, followed by the inclination layer. The polycrystalline layer is weakest in trapping dislocations.

Regardless of the dot type and the stripe-type, the mask provided on the underlying substrate has a pitch and an exposed portion much greater than those of the ELO (diameter from 1 to 2µm, pitch from 3 to 5µm; small exposed portion). Therefore, a structure including different portions such as dislocation-reduced facet growth crystal region 5z, dislocation-reduced C face growth crystal region 5y and dislocation-concentrated crystal region 5h can be obtained.

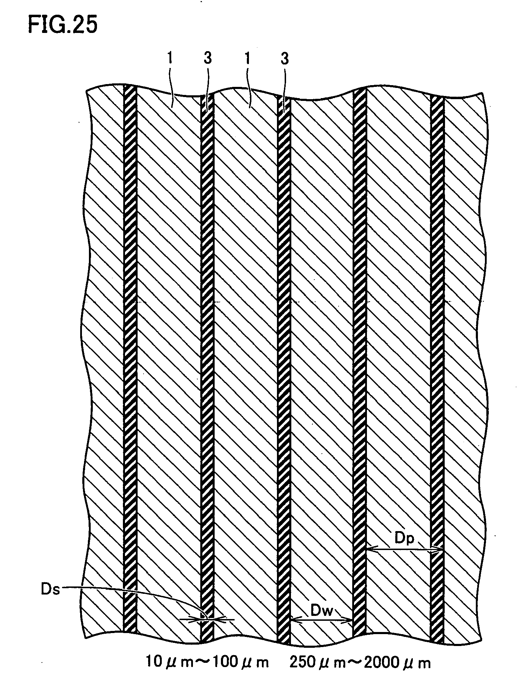

As shown in Fig. 25, as to the dimension of the striped mask 3, width Ds of the mask-coated portion of the underlying substrate 1 is set to 10µm to 100µm and interval Dw between the adjacent coating portions is set to 250µm to 2000µm.

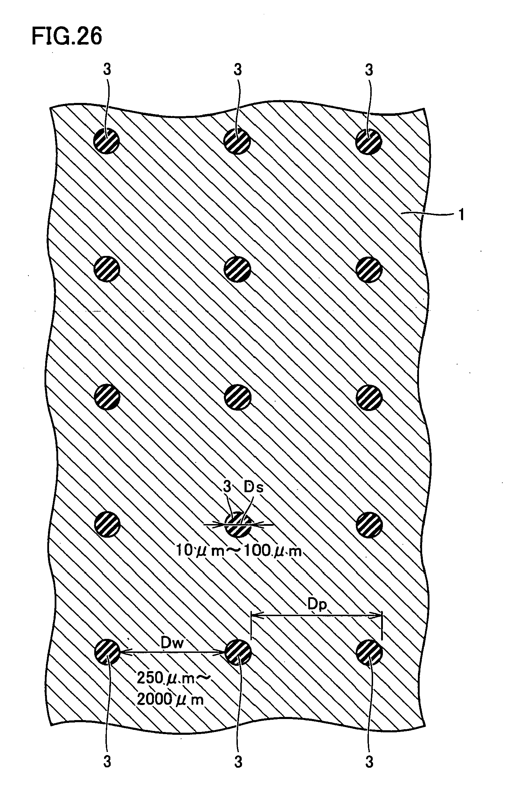

As shown in Fig. 26, as to the dimension of the dotted mask 3, diameter Ds of the mask-coated portion of the underlying substrate 1 is set to 10µm to 100µm and interval Dw between the adjacent coating portions is set to 250µm to 2000µm. When the diameter of the coating portion (mask portion) is less than 10µm, dislocation-concentrated crystal region 5h is not successfully formed or maintained, and even if dislocation-concentrated crystal region 5h is formed, it disappears. Even though the interval between the coating portions (mask portions) exceeds 2000µm, the structure of dislocation-concentrated crystal region 5h/dislocation-reduced facet growth crystal region 5z/dislocation-reduced C face growth crystal region 5y can be formed, however, dislocations cannot completely be trapped in dislocation-concentrated crystal region 5h unless the crystal is considerably thick.

When the mask has a small dimension as in the ELO method, the surface becomes flat (C face) with the growth of the crystal and influence of the mask will soon be eliminated. If the mask has a large dimension, however, it is difficult to obtain the flat surface even though growth proceeds. According to the facet growth method (Patent Documents 9 and 10), the facet is maintained until the end to reduce dislocations.

In addition, there is a further problem of warpage or crack. If the iron-doped GaN is grown on the underlying substrate without a mask with the C face being maintained as in Patent Document 11, the iron-doped GaN may crack or may significantly be warped when it is completed as a free-standing substrate.

According to the present invention, a structure portion different in type such as dislocation-reduced facet growth crystal region 5z, dislocation-concentrated crystal region 5h, and dislocation-reduced C face growth crystal region 5y is present in a mixed manner in the crystal, so that internal stress in the crystal is lessened. In order to achieve this, a mask at large pitch Dp (interval Dw and width Ds are both great; Dp = Ds+Dw) is used to form a structure such as dislocation-reduced facet growth crystal region 5z, dislocation-concentrated crystal region 5h, and dislocation-reduced C face growth crystal region 5y. If the facet is dominantly formed, however, oxygen is introduced. Accordingly, the crystal is fabricated so as to attain the I type having a flat surface where possible, by raising a temperature and lowering group V/group III ratio R_{5/3}. The I type is further desirable.

Meanwhile, as the II type can attain the semi-insulating property and warpage or crack thereof is satisfactory, the II type is also applicable and encompassed in the scope of the present invention.

The mask having a large diameter (width) and provided at a large interval as described above is formed on the underlying substrate, the nitride semiconductor crystal is grown on the underlying substrate with the HVPE method by setting the substrate temperature to 1040°C or higher and supplying a group V raw material and a group III raw material of which group V/group III ratio R_{5/3} is in a range from 1 to 10 and an iron compound gas raw material, and thereafter the underlying substrate is removed. Here, a method of removing underlying substrate 1 from nitride semiconductor crystal 5 is not particularly limited, and a method such as cutting or grinding is employed. The gist of the present invention resides in fabrication of a free-standing iron-doped nitride semiconductor crystal containing a relatively small amount of oxygen and achieving less warpage and low crack generation ratio.

### [Examples]

GaAs having a (111) Ga surface was employed as the underlying substrate and a dotted mask or a striped mask was formed. The mask was composed of SiO₂ and had a thickness from 60nm to 200nm. Dimensions of the mask (diameter or width Ds, interval Dw, and pitch Dp) will be described later. A GaN film grew on the mask with the HVPE method. Initially, a buffer layer was formed, and thereafter a thick epitaxially grown layer was formed. Conditions for the buffer layer were as follows.

Regarding the conditions for growing the buffer layer, the substrate temperature was set to 500°C to 550°C, GaCl partial pressure P_{GaCl} was set to 80Pa (0.0008atm), NH₃ partial pressure P_{NH3} was set to 16kPa (0.16atm), and the buffer layer had the thickness of 50nm.

Group V/group III ratio R_{5/3} in growing the buffer layer was set to 200. In the present invention, importance is placed on the growth temperature and group V/group III ratio R_{5/3}, however, it is values thereof during epitaxial growth (thick film growth) that are made much of. Group V/group III ratio R_{5/3} during formation of the buffer layer does not matter.

"Crack generation" in the substrate refers to generation of a linear crack in the surface not shorter than 2.0mm, generation of at least three linear cracks in the surface of a length from 0.5mm to 2.0mm, or generation of at least 21 linear cracks in the surface of a length from 0.3mm to 0.5mm.

"No crack generation" in the substrate refers to generation of 0 linear cracks in the surface not shorter thar 2.0mm, generation of at most two linear cracks of a length from 0.5mm to 2.0mm, or generation of at most 20 cracks of a length from 0.3mm to 0.5mm.

The crack generation ratio (%) refers to a value obtained by dividing the number of substrates in which a crack is generated among the grown substrates by the total number of substrates and by multiplying the result by 100. A donor concentration C_{D} refers to a concentration of an n-type impurity. As doping with Si is not performed here, the donor is oxygen (O). Namely, donor concentration C_{D} refers to a concentration of oxygen forming a donor level. Both of the oxygen concentration and the iron concentration were measured with SIMS (secondary ion mass spectroscopy). The warpage of the substrate is expressed by a radius of curvature R (unit: m). A large number of experiments were repeatedly conducted.

Here, 45 samples will be described. The samples were numbered from 1 to 45. Samples 1 to 36, 44, and 45 represent the examples of the present invention, while samples 37 to 43 represent comparative examples. Among the examples corresponding to samples 1 to 36, 44, and 45, samples 1 to 21 and 44 are I type (flat surface), and samples 22 to 36 and 45 are II type (chevron-shaped surface).

In the comparative examples, the underlying substrate is not provided with the mask and the crystal is vapor-deposited directly on the flat underlying substrate. Comparative examples 3 7 to 43 were particularly experimented in order to confirm effect of the mask and they do not belong to the conventional art. In some of the comparative examples, the temperature and group V/group III ratio R_{5/3} were within a range of limitations of the present invention.

Table 1 shows a sample number, a mask interval (unit: µm), a mask width or diameter (unit: µm), a growth temperature (°C), PGa (indicating a GaCl partial pressure; unit: kPa), PN (indicating an ammonia partial pressure; unit: kPa), a substrate dimension (unit: mm or inch (")), a thickness (unit: µ), a core (dislocation-concentrated crystal region 5h) type; a crystal face type, an Fe concentration C_{Fe} (unit: cm⁻³), donor concentration C_{D} (corresponding to oxygen concentration; unit: cm⁻³), a specific resistance (Ωcm), a crack generation ratio (%), and a radius of curvature of warpage (unit: m).

**Table 1**

| Sample No. | Mask Interval (µm) | Mask Width or Diameter (µm) | Growth Temperature (°C) | Partial | Substrate Dimension | Thickness (µm) | Core Type | Crystal Face Type | Fe Concent ration (cm⁻³) | Donor Concent ration (cm⁻³) | Specific Resistance (Ωcm) | Ratio of Crack Generation (%) | Radius of Curvature of Warpage (m) |
|---|---|---|---|---|---|---|---|---|---|---|---|---|---|
| 1 | 500 | 50 | 1110 | PGa: 4kPa | 18mm | 400 | Inversion layer | I | 1×10¹⁷ | 1×10¹⁵ | 1×10⁷ | 4 | 5.6 |
| | | | | PN: 10kPa | | | | | | | | | |
| 2 | 500 | 50 | 1110 | PGa: 4kPa | 2" | 400 | Inversion layer | I | 1×10¹⁷ | 1×10¹⁵ | 1×10⁷ | 12 | 5.2 |
| | | | | PN: 10kPa | | | | | | | | | |
| 3 | 500 | 50 | 1110 | PGa: 4kPa | 3" | 400 | Inversion layer | I | 1×10¹⁷ | 1×10¹⁵ | 1×10⁷ | 18 | 6.0 |
| | | | | PN: 10kPa | | | | | | | | | |
| 4 | 500 | 50 | 1110 | PGa: 4kPa | 2" | 400 | Inversion layer | I | 1×10¹⁶ | 1×10¹⁵ | 1×10⁶ | 12 | 5.8 |
| | | | | PN: 10kPa | | | | | | | | | |
| 5 | 500 | 50 | 1110 | PGa: 10kPa | 2" | 400 | Inversion layer | I | 1×10¹⁶ | 1×10¹⁵ | 1×10⁶ | 12 | 5.9 |
| | | | | PN: 10kPa | | | | | | | | | |
| 6 | 500 | 50 | 1110 | PGa: 3.3kPa | 2" | 400 | Inversion layer | I | 1×10¹⁶ | 1×10¹⁵ | 1×10⁶ | 15 | 5.8 |
| | | | | PN: 10kPa | | | | | | | | | |
| 7 | 500 | 50 | 1110 | PGa: 4kPa | 2" | 400 | Inversion layer | I | 1×10¹⁹ | 1×10¹⁵ | 1×10¹¹ | 26 | 5.6 |
| | | | | PN: 10kPa | | | | | | | | | |
| 8 | 500 | 50 | 1110 | PGa: 4kPa | 2" | 400 | Inversion layer | I | 5×10¹⁹ | 1×10¹⁵ | 1×10¹² | 20 | 5.9 |
| | | | | PN: 10kPa | | | | | | | | | |
| 9 | 500 | 50 | 1110 | PGa: 4kPa | 2" | 400 | Polycrystalline | I | 1×10¹⁷ | 1×10¹⁵ | 1×10⁷ | 16 | 5.7 |
| | | | | PN: 10kPa | | | | | | | | | |
| 10 | 500 | 50 | 1110 | PGa: 4kPa | 2" | 400 | Inclination layer | I | 1×10¹⁷ | 1×10¹⁵ | 1×10⁷ | 17 | 5.9 |
| | | | | PN: 10kPa | | | | | | | | | |
| 11 | 500 | 10 | 1110 | PGa: 4kPa | 2" | 400 | Inversion layer | I | 1×10¹⁷ | 1×10¹⁵ | 1×10⁷ | 17 | 5.2 |
| | | | | PN: 10kPa | | | | | | | | | |
| 12 | 500 | 25 | 1110 | PGa: 4kPa | 2" | 400 | Inversion layer | I | 1×10¹⁷ | 1×10¹⁵ | 1×10⁷ | 19 | 5.2 |
| | | | | PN: 10kPa | | | | | | | | | |
| 13 | 500 | 100 | 1110 | PGa: 4kPa | 2" | 400 | Inversion layer | I | 1×10¹⁷ | 1×10¹⁵ | 1×10⁷ | 19 | 5.1 |
| | | | | PN: 10kPa | | | | | | | | | |
| 14 | 250 | 50 | 1110 | PGa: 4kPa | 2" | 400 | Inversion layer | I | 1×10¹⁷ | 1×10¹⁵ | 1×10⁷ | 18 | 6.0 |
| | | | | PN: 10kPa | | | | | | | | | |
| 15 | 750 | 50 | 1110 | PGa: 4kPa | 2" | 400 | Inversion layer | I | 1×10¹⁷ | 1×10¹⁵ | 1×10⁷ | 18 | 5.9 |
| | | | | PN: 10kPa | | | | | | | | | |
| 16 | 1000 | 50 | 1110 | PGa: 4kPa | 2" | 400 | Inversion layer | I | 1×10¹⁷ | 1×10¹⁵ | 1×10⁷ | 17 | 5.7 |
| | | | | PN: 10kPa | | | | | | | | | |
| 17 | 1500 | 50 | 1110 | PGa: 4kPa | 2" | 400 | Inversion layer | I | 1×10¹⁷ | 1×10¹⁵ | 1×10⁷ | 19 | 3.9 |
| | | | | PN: 10kPa | | | | | | | | | |
| 18 | 2000 | 50 | 1110 | PGa: 4kPa | 2" | 400 | Inversion layer | I | 1×10¹⁷ | 1×10¹⁵ | 1×10⁷ | 17 | 3.3 |
| | | | | PN: 10kPa | | | | | | | | | |
| 19 | 500 | 50 | 1110 | PGa: 4kPa | 2" | 400 | Inversion layer | I | 1×10¹⁷ | 1×10¹⁷ | 1×10⁵ | 24 | 5.5 |
| | | | | PN: 10kPa | | | | | | | | | |
| 20 | 500 | 50 | 1110 | PGa: 4kPa | 2" | 400 | Inversion layer | I | 1×10¹⁹ | 1×10¹⁷ | 1×10⁷ | 16 | 5.2 |
| | | | | PN: 10kPa | | | | | | | | | |
| 21 | 500 | 50 | 1110 | PGa: 4kPa | 2" | 400 | Inversion layer | I | 5×10¹⁹ | 1×10¹⁷ | 1×10⁸ | 27 | 5.3 |
| | | | | PN: 10kPa | | | | | | | | | |
| 22 | 500 | 50 | 1050 | PGa: 4kPa | 2" | 400 | Inversion layer | II | 1×10¹⁷ | 1×10¹⁵ | 1×10⁷ | 17 | 5.0 |
| | | | | PN: 10kPa | | | | | | | | | |
| 23 | 500 | 50 | 1050 | PGa: 4kPa | 2" | 400 | Inversion layer | II | 1×10¹⁶ | 1×10¹⁵ | 1×10⁶ | 13 | 5.5 |
| | | | | PN: 10kPa | | | | | | | | | |
| 24 | 500 | 50 | 1050 | PGa: 4kPa | 2" | 400 | Inversion layer | II | 1×10¹⁹ | 1×10¹⁷ | 1×10⁷ | 16 | 5.7 |
| | | | | PN: 10kPa | | | | | | | | | |
| 25 | 500 | 50 | 1050 | PGa: 4kPa | 2" | 400 | Inversion layer | II | 5×10¹⁹ | 1×10¹⁷ | 1×10⁸ | 29 | 5.3 |
| | | | | PN: 10kPa | | | | | | | | | |
| 26 | 500 | 50 | 1050 | PGa: 4kPa | 2" | 400 | Inversion layer | II | 7×10¹⁹ | 1×10¹⁹ | 1×10⁵ | 29 | 6.0 |
| | | | | PN: 10kPa | | | | | | | | | |
| 27 | 500 | 50 | 1050 | PGa: 4kPa | 2" | 400 | Inversion layer | II | 8×10¹⁹ | 1×10¹⁹ | 1×10⁷ | 28 | 5.1 |
| | | | | PN: 10kPa | | | | | | | | | |
| 28 | 500 | 50 | 1050 | PGa: 4kPa | 2" | 400 | Inversion layer | II | 1×10¹⁷ | 1×10¹⁷ | 1×10⁵ | 23 | 5.7 |
| | | | | PN: 10kPa | | | | | | | | | |
| 29 | 500 | 50 | 1050 | PGa: 4kPa | 2" | 400 | Inversion layer | II | 1×10¹⁹ 1×10¹⁹ | 1×10¹⁵ | 1×10¹¹ | 27 | 5.4 |
| | | | | PN: 10kPa | | | | | | | | | |
| 30 | 500 | 50 | 1050 | PGa: 4kPa | 2" | 400 | Inversion layer | II | 5×10¹⁹ | 1×10¹⁵ | 1×10¹² | 18 | 5.7 |
| | | | | PN: 10kPa | | | | | | | | | |
| 31 | 500 | 50 | 1050 | PGa: 4kPa | 2" | 400 | Inversion layer | II | 7×10¹⁹ | 1×10¹⁹ | 1×10⁵ | 27 | 6.0 |
| | | | | PN: 10kPa | | | | | | | | | |
| 32 | 500 | 50 | 1050 | PGa: 4kPa | 2" | 400 | Inversion layer | II | 8×10¹⁹ | 1×10¹⁹ | 1×10⁷ | 29 | 5.6 |
| | | | | PN: 10kPa | | | | | | | | | |
| 33 | 500 | 50 | 1050 | PGa: 4kPa | 2" | 400 | Inversion layer | II | 7×10¹⁹ | 1×10¹⁵ | 3×10¹² | 27 | 5.5 |
| | | | | PN: 10kPa | | | | | | | | | |
| 34 | 500 | 50 | 1050 | PGa: 4kPa PN: 10kPa | 2" | 400 | Inversion layer | II | 8×10¹⁹ | 1×10¹⁵ | 5×10¹² | 28 | 5.0 |
| 35 | 500 | 50 | 1050 | PGa: 2kPa PN: 10kPa | 2" | 400 | Inversion layer | II | 7×10¹⁹ | 1×10¹⁹ | 1×10⁵ | 29 | 5.0 |
| 36 | 500 | 50 | 1050 | PGa: 1kPa PN: 10kPa | 2" | 400 | Inversion layer | II | 8×10¹⁹ | 1×10¹⁹ | 1×10⁷ | 28 | 5.0 |
| 37 | Comparative Example | - | 1050 | PGa: 4kPa PN: 10kPa | 2" | 400 | - | C face | 1×10¹⁷ | 1×10¹⁵ | 1×10⁷ | 77 | 1.4 |
| 38 | Comparative Example | - | 1050 | PGa: 4kPa PN: 10kPa | 2" | 400 | - | C face | 1×10¹⁶ | 1×10¹⁵ | 1×10⁶ | 75 | 1.6 |
| 39 | Comparative Example | - | 1030 | PGa: 4kPa PN: 10kPa | 2" | 400 | - | C face | 1×10¹⁹ | 1×10¹⁵ | 1×10¹¹ | 88 | 1.9 |
| 40 | Comparative Example | - | 1030 | PGa: 4kP PN: 10kPa | 2" | 400 | - | C face | 5×10¹⁹ | 1×10¹⁵ | 1×10¹² | 97 | 1.8 |
| 41 | Comparative Example | - | 1010 | PGa: 4kPa PN: 10kPa | 2" | 400 | - | C face | 1×10¹⁷ | 1×10¹⁷ | 1×10⁵ | 68 | 1.4 |
| 42 | Comparetive Example | - | 1010 | PGa: 4kPa PN: 10kPa | 2" | 400 | - | C face | 1×10¹⁹ | 1×10¹⁷ | 1×10⁷ | 90 | 1.4 |
| 43 | Comparative Example | - | 1050 | PGa: 4kPa PN: 10kPa | 2" | 400 | - | C face | 5×10¹⁹ | 1×10¹⁷ | 1×10⁸ | 95 | 1.6 |
| 44* | 500 | 50 | 1100 | PGa: 4kPa PN: 10kPa | 2" | 400 | Inversion layer | I | 1×10¹⁷ | 1×10¹⁵ | 1×10⁷ | 20 | 3.2 |
| 45* | 500 | 50 | 1050 | PGa: 4kPa PN: 10kPa | 2" | 400 | Inversion layer | II | 1×10¹⁷ | 1×10¹⁵ | 1×10⁷ | 18 | 4.0 |

| | | | | | | | | | | | | | |
|---|---|---|---|---|---|---|---|---|---|---|---|---|---|
| * Samples 44 and 45 are dot types. | | | | | | | | | | | | | |

### [Example A: Example of Semi-Insulating Substrate]

### [Sample 1 (Example; I Type)]

A parallel-stripe mask having mask width Ds of 50µm was formed at mask interval Dw of 500µm on a GaAs substrate of 18mm square. Sample 1 is characterized by the use of a wafer of 18mm square as the underlying substrate. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm.

The GaAs substrate was processed and removed, to obtain a GaN crystal free-standing substrate having a thickness of 400µm. Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1 × 10¹⁵ cm⁻³, which is an extremely low donor concentration value. Iron concentration C_{Fe} was 1 × 10¹⁷ cm⁻³, and an amount of introduction of iron is small. The specific resistance was 1×10⁷Ωcm. Insulation was relatively low, because the iron concentration is low. Nevertheless, the substrate can be used as the semi-insulating substrate. A crack generation ratio K was 4%, which is extremely low and lowest among all samples. Radius of curvature R of warpage was 5.6m, and warpage is sufficiently small.

### [Sample 2 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm.

The GaAs substrate was removed, to obtain a GaN crystal free-standing substrate having a thickness of 400µm. Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1×10¹⁷cm⁻³, and an amount of introduction of iron is small. The specific resistance was 1 × 10⁷Ωcm. Insulation was relatively low, because the iron concentration is low. Nevertheless, the substrate can be used as the semi-insulating substrate. Crack generation ratio K was 12%, which is extremely low. Radius of curvature R of warpage was 5.2m, and warpage is sufficiently small.

### [Sample 3 (Example; I Type)]

A parallel-stripe mask having mask width Ds of 50µm was formed at mask interval Dw of 500µm on a GaAs substrate of 3 inches (75mm) in diameter. Sample 3 is characterized by a large dimension of the substrate. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm.

The GaAs substrate was removed, to obtain a GaN crystal free-standing substrate having a thickness of 400µm. Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1 × 10¹⁵ cm⁻³, which is an extremely low donor concentration value. Iron concentration C_{Fe} was 1×10¹⁷cm⁻³, and an amount of introduction of iron is small. The specific resistance was 1 × 10⁷ Ωcm. Insulation was relatively low, because the iron concentration is low. Nevertheless, the substrate can be used as the semi-insulating substrate. Crack generation ratio K was 18%, which is extremely low. Radius of curvature R of warpage was 6.0m, and warpage is sufficiently small.

### [Sample 4 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm.

The GaAs substrate was removed, to obtain a GaN crystal free-standing substrate having a thickness of 400µm. Group V/group III ratio R_{5/3} was set to 2.5.

The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1×10¹⁶cm⁻³, and an amount of introduction of iron is small. The specific resistance was 1 × 10⁶Ωcm. Insulation was relatively low, because the iron concentration is low. Nevertheless, the substrate can be used as the semi-insulating substrate. Crack generation ratio K was 12%, which is extremely low. Radius of curvature R of warpage was 5.8m, and warpage is sufficiently small.

### [Sample 5 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1 atm), and GaCl partial pressure P_{GaCl} was set to 10kPa (0.1atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 1. This sample is characterized in that group V/group III ratio R_{5/3} was set to 1. Such a low group V/group III ratio R_{5/3} has never been set in growing a GaN crystal. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1×10¹⁶cm⁻³, and an amount of introduction of iron is small. The specific resistance was 1×10⁶Ωcm. Insulation was relatively low, because the iron concentration is low. Nevertheless, the substrate can be used as the semi-insulating substrate. Crack generation ratio K was 12%, which is extremely low. Radius of curvature R of warpage was 5.9m, and warpage is sufficiently small.

### [Sample 6 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 3.3kPa (0.033atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm. Group V/group III ratio R_{5/3} was set to 3. This sample is characterized in that group V/group III ratio R_{5/3} was set to 3.

The GaN crystal free-standing substrate included the parallel-stripe core (dislocation-concentrated region 5h) having core width Ds of 50µm and repeated at core interval Dw of 50µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1 ×10¹⁶ cm⁻³, and an amount of introduction of iron is small. The specific resistance was 1×10⁶Ωcm. Insulation was relatively low, because the iron concentration is low. Nevertheless, the substrate can be used as the semi-insulating substrate. Crack generation ratio K was 15%, which is extremely low. Radius of curvature R of warpage was 5.8m, and warpage is sufficiently small.

### [Sample 7 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1×10¹⁹cm⁻³, and a large amount of iron was taken in. The specific resistance was 1×10¹¹Ωcm. Insulation was extremely high. Insulation was high because oxygen (donor) is less and the iron concentration is high. The substrate can be used as the semi-insulating substrate. Crack generation ratio K was 26%, which is relatively low. Radius of curvature R of warpage was 5.6m, and warpage is sufficiently small. This sample is characterized by high insulation.

### [Sample 8 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an extremely low donor concentration value. Iron concentration C_{Fe} was 5x 10¹⁹cm⁻³, and an extremely large amount of iron was taken in. The specific resistance was 1 ×10¹²Ωcm. Insulation was exceedingly high. Insulation was high because oxygen (donor) is less and the iron concentration is high. The substrate can be used as the semi-insulating substrate. Crack generation ratio K was 20%, which is relatively low. Radius of curvature R of warpage was 5.9m, and warpage is sufficiently small. This sample is characterized by particularly high insulation.

### [Sample 9 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm.

The GaAs substrate was removed, to obtain a GaN crystal free-standing substrate having a thickness of 400µm. Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the polycrystalline layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1×10¹⁷cm⁻³, and quite an amount of iron was taken in. The specific resistance was 1×10⁷Ωcm. Insulation was not high, however, the substrate can be used as the semi-insulating substrate. Crack generation ratio K was 16%, which is extremely low. Radius of curvature R of warpage was 5.7m, and warpage is sufficiently small. This sample is characterized in that the crystal on the mask is of the polycrystalline type, instead of the inversion layer. Crack, warpage, specific resistance, or the like is not so different from those in an example where the crystal on the mask is of the type of the inversion layer.

### [Sample 10 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inclination layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1×10¹⁷cm⁻³, and quite an amount of iron was taken in. The specific resistance was 1 ×10⁷Ωcm. Insulation was not high, however, the substrate can be used as the semi-insulating substrate. Crack generation ratio K was 17%, which is extremely low. Radius of curvature R of warpage was 5.9m, and warpage is sufficiently small. This sample is characterized in that the crystal on the mask is of the type of the inclination layer, instead of the inversion layer. Crack, warpage, specific resistance, or the like is not so different from those in an example where the crystal on the mask is of the type of the inversion layer.

### [Sample 11 (Example; I Type)]

A parallel-stripe mask having mask width Ds of 10µm was formed at mask interval Dw of 500µm on a GaAs substrate of 2 inches (50mm) in diameter. This sample is characterized in that stripe mask width Ds was as narrow as 10µm (0.01mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 10µm was formed on the parallel-stripe mask having a mask width of 10µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 10µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵m⁻³, which is an extremely low donor concentration value. Iron concentration C_{Fe} was 1×l0¹⁷cm⁻³, and quite an amount of iron was taken in. The specific resistance was 1 × 10⁷Ωcm. Insulation was not high, however, the substrate can be used as the semi-insulating substrate. Crack generation ratio K was 17%, which is extremely low. Radius of curvature R of warpage was 5.2m, and warpage is sufficiently small. If mask width Ds is small, warpage may be greater or smaller. On the other hand, even though mask width Ds was set to 10µm, warpage did not become so great. Warpage was not different whether mask width Ds was set to 10µm or 50µm.

### [Sample 12 (Example; I Type)]

A parallel-stripe mask having mask width Ds of 25µm was formed at mask interval Dw of 500µm on a GaAs substrate of 2 inches (50mm) in diameter. This sample is characterized in that stripe mask width Ds was as narrow as 25µm (0.025mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 25µm was formed on the parallel-stripe mask having a mask width of 25µm. The GaAs substrate was removed, to obtain a GaN crystal free-standing substrate having a thickness of 400µm. Group V/group III ratio R_{5/3} was set to 2.5.

The GaN crystal free-standing substrate included the parallel-stripe core (dislocation-concentrated region 5h) having core width Ds of 25µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an exceedingly low donor concentration value. Iron concentration C_{Fe} was 1x10¹⁷cm⁻³, and quite an amount of iron was taken in. The specific resistance was 1 ×10⁷Ωcm. Insulation was not high, however, the substrate can be used as the semi-insulating substrate. Crack generation ratio K was 19%, which is extremely low. Radius of curvature R of warpage was 5.2m, and warpage is sufficiently small. If mask width Ds is small, warpage may be greater or smaller. On the other hand, even though mask width Ds was set to 25µm, warpage did not become so great. Warpage was not different whether mask width Ds was set to 25µm or 50µm.

### [Sample 13 (Example; I Type)]

A parallel-stripe mask having mask width Ds of 100µm was formed at mask interval Dw of 500µm on a GaAs substrate of 2 inches (50mm) in diameter. This sample is characterized in that stripe mask width Ds was as great as 100µm (0.1mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 100µm was formed on the parallel-stripe mask having a mask width of 100µm. The GaAs substrate was removed, to obtain a GaN crystal free-standing substrate having a thickness of 400µm. Group V/group III ratio R_{5/3} was set to 2.5. The GaN crystal free-standing substrate included the parallel-stripe core (dislocation-concentrated region 5h) having core width Ds of 100µm and repeated at core interval Dw of 500µm. The crystal type of the core (dislocation-concentrated crystal region 5h) was the inversion layer. The crystal face type was I type. As growth temperature Tq was high, I type was obtained.

Donor concentration C_{D} was 1×10¹⁵cm⁻³, which is an extremely low donor concentration value. Iron concentration C_{Fe} was 1×10¹⁷ cm⁻³, and quite an amount of iron was taken in. The specific resistance was 1 ×10⁷Ωcm. Insulation was not high, however, the substrate can be used as the semi-insulating substrate. Crack generation ratio K was 19%, which is extremely low Radius of curvature R of warpage was 5.1m, and warpage is sufficiently small. If mask width Ds is great, warpage may be greater or smaller. On the other hand, even though mask width Ds was set to 100µm, warpage did not become so great. Warpage was not different whether mask width Ds was set to 100µm or 50µm.

### [Sample 14 (Example; I Type)]

A parallel-stripe mask having mask width Ds of 50µm was formed at mask interval Dw of 250µm on a GaAs substrate of 2 inches (50mm) in diameter. This sample is characterized in that stripe mask interval Dw was as narrow as 250µm (0.25mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 250µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is a low donor concentration value. Iron concentration C_{Fe} was 1×10¹⁷cm⁻³, and quite an amount of iron was taken in. The specific resistance was 1×10¹⁷Ωcm, Insulation was not high, however, the substrate can be used as the semi-insulating substrate. Crack generation ratio K was 18%, which is extremely low. Radius of curvature R of warpage was 6.0m, and warpage is sufficiently small. If mask interval Dw is small, warpage and crack may be less. On the other hand, warpage or the crack was not so different whether mask interval Dw was set to 500µm or 250µm.

### [Sample 15 (Example; I Type)]

A parallel-stripe mask having mask width Ds of 50µm was formed at mask interval Dw of 750µm on a GaAs substrate of 2 inches (50mm) in diameter. This sample is characterized in that stripe mask interval Dw was as great as 750µm (0.75mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm. Group V/group III ratio R_{5/3} was set to 2.5. The GaN crystal free-standing substrate included the parallel-stripe core (dislocation-concentrated region 5h) having core width Ds of 50µm and repeated at core interval Dw of 750µm. The crystal type of the core (dislocation-concentrated crystal region 5h) was the inversion layer. The crystal face type was I type. As growth temperature Tq was high, I type was obtained.

Donor concentration C_{D} was 1×10¹⁵cm⁻³, which is a low donor concentration value. Iron concentration C_{Fe} was 1×10¹⁷cm⁻³, and quite an amount of iron was taken in. The specific resistance was 1×10⁷Ωcm. Insulation was not high, however, the substrate can be used as the semi-insulating substrate. Crack generation ratio K was 18%, which is extremely low. Radius of curvature R of warpage was 5.9m, and warpage is sufficiently small. If mask interval Dw is great, warpage may become greater. On the other hand, even though mask interval Dw was set to 750µm, warpage still did not become great.

### [Sample 16 (Example; I Type)]

A parallel-stripe mask having mask width Ds of 50µm was formed at mask interval Dw of 1000µm on a GaAs substrate of 2 inches (50mm) in diameter. This sample is characterized in that stripe mask interval Dw was as great as 1000µm (1mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 1000µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is a low donor concentration value. Iron concentration C_{Fe} was 1×10¹⁷cm⁻³, and quite an amount of iron was taken in. The specific resistance was 1×10⁷Ωcm. Insulation was not high, however, the substrate can be used as the semi-insulating substrate. Crack generation ratio K was 17%, which is extremely low. Radius of curvature R of warpage was 5.7m, and warpage is sufficiently small. If mask interval Dw is great, warpage may become greater. On the other hand, even though mask interval Dw was set to 100µm, warpage still did not become great.

### [Sample 17 (Example; I Type)]

A parallel-stripe mask having mask width Ds of 50µm was formed at mask interval Dw of 1500µm on a GaAs substrate of 2 inches (some) in diameter. This sample is characterized in that stripe mask interval Dw was as great as 1500µm (1.5mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 1500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³ which is a low donor concentration value. Iron concentration C_{Fe} was 1 × 10¹⁷cm⁻³, and quite an amount of iron was taken in. The specific resistance was 1×10⁷Ωcm. Insulation was not high, however, the substrate can be used as the semi-insulating substrate. Crack generation ratio K was 19%, which is extremely low. Radius of curvature R of warpage was 3.9m, and warpage is relatively great. Warpage is great probably because of large mask interval Dw (Dw = 1500µm). If a radius of curvature of the maximum allowable warpage is in a range from 2m to 3.5m, the substrate according to this sample can also be used. If the radius of the maximum allowable curvature of warpage is in a range from 4m to 5m, this sample is a failure. An allowable warpage value is different depending on a purpose.

### [Sample 18 (Example; I Type)]

A parallel-stripe mask having mask width Ds of 50µm was formed at mask interval Dw of 2000µm on a GaAs substrate of 2 inches (50mm) in diameter. This sample is **characterized in that** stripe mask interval Dw was as great as 2000µm (2mm). After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm. Group V/group III ratio R_{5/3} was set to 2.5. The GaN crystal free-standing substrate included the parallel-stripe core (dislocation-concentrated region 5h) having core width Ds of 50µm and repeated at core interval Dw of 2000µm. The crystal type of the core (dislocation-concentrated crystal region 5h) was the inversion layer.

The crystal face type was I type. As growth temperature Tq was high, I type was obtained. Donor concentration C_{D} was 1×10¹⁵cm⁻³, which is a low donor concentration value. Iron concentration C_{Fe} was 1×10¹⁷cm⁻³, and quite an amount of iron was taken in. The specific resistance was 1 ×10⁷Ωcm. Insulation was not high, however, the substrate can be used as the semi-insulating substrate. Crack generation ratio K was 17%, which is extremely low. Radius of curvature R of warpage was 3.3m, and warpage is relatively great. Warpage is great probably because of large core interval Dw (Dw = 2000µm). If a radius of the maximum allowable curvature of warpage is in a range from 2m to 3m, the substrate according to this sample can also be used. If the radius of curvature of the maximum allowable warpage is in a range from 3.5m to 5m, this sample is a failure. An allowable warpage value is different depending on a purpose.

### [Sample 19 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁷cm⁻³, which is a considerably high donor concentration value. Iron concentration C_{Fe} was 1×10¹⁷cm⁻³, and quite an amount of iron was taken in. The specific resistance was 1x 10⁵Ωcm. Insulation was extremely low. Nevertheless, the substrate can be used as the semi-insulating substrate. Crack generation ratio K was 24%. Though crack generation is relatively likely, the substrate can be used as the semi-insulating substrate. Radius of curvature R of warpage was 5.5m, and warpage is less.

### [Sample 20 (Example; I Type)]

A parallel-stripe mask haying mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁷cm⁻³, which is a considerably high donor concentration value. Iron concentration C_{Fe} was 1×10¹⁹cm⁻³, and a large amount of iron was taken in. The specific resistance was 1 × 10⁷Ωcm. Insulation was not so high. Nevertheless, the substrate can be used as the semi-insulating substrate. Crack generation ratio K was 16%. A good semi-insulating substrate in which crack generation is less likely could be obtained. Radius of curvature R of warpage was 5.2m, and warpage is less.

### [Sample 21 (Example; I Type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Initially, an epitaxial growth temperature Tg was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. Thereafter, epitaxial growth temperature Tq was set to 1110°C, NH₃ partial pressure P_{NH3} was set to 10kPa (0.1atm), and GaCl partial pressure P_{GaCl} was set to 4kPa (0.04atm), and epitaxial growth was performed until the thickness attains to 1000µm or more. A parallel-stripe core (dislocation-concentrated region 5h) of the GaN crystal having a core width of 50µm was formed on the parallel-stripe mask having a mask width of 50µm. The GaAs substrate was removed and the GaN substrate was cut from the portion obtained in growth at 1100°C, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁷cm⁻³, which is a considerably high donor concentration value. Iron concentration C_{Fe} was 5×10¹⁹cm⁻³, and a large amount of iron was taken in. The specific resistance was 1×110⁸Ωcm. Insulation was relatively high. The substrate can be used as the semi-insulating substrate. Crack generation ratio K was 27%. Though crack generation is considerably likely, the substrate can be used as the semi-insulating substrate. Radius of curvature R of warpage was 5.3m, and warpage is less.

### [Sample 22 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁵cm⁻³, which is an extremely low donor concentration value. Iron concentration C_{Fe} was 1 × 10¹⁷cm⁻³ , and quite an amount of iron was taken in. The specific resistance was 1 × 10⁷Ωcm. Insulation was not so high. Nevertheless, the substrate can be used as the semi-insulating substrate. Crack generation ratio K was 17%. A good semi-insulating substrate in which crack generation is less likely could be obtained. Radius of curvature R of warpage was 5.0m, and warpage is less.

### [Sample 23 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{MH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁵cm⁻³, which is an extremely low donor concentration value. Iron concentration C_{Fe} was 1×10¹⁶cm⁻³, and quite an amount of iron was taken in. The specific resistance was 1×10⁶Ωcm. Insulation was relatively low. Nevertheless, the substrate can be used as the semi-insulating substrate. Crack generation ratio K was 13%. A good semi-insulating substrate in which crack generation is less likely could be obtained. Radius of curvature R of warpage was 5.5m, and warpage is less.

### [Sample 24 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1×10¹⁷cm⁻³, which is a considerably high value. Iron concentration C_{F}. was 1×10¹⁹cm⁻³, and a large amount of iron was taken in. The specific resistance was 1×10⁷Ωcm. Insulation was not high, however, the substrate can be used as the semi-insulating substrate. Crack generation ratio K was 16%. A good semi-insulating substrate in which crack generation is less likely could be obtained. Radius of curvature R of warpage was 5.7m, and warpage is less.

### [Sample 25 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1×10¹⁷cm⁻³, which is a considerably high value. Iron concentration C_{Fe} was 5×10¹⁹cm⁻³, and an extremely large amount of iron was taken in. The specific resistance was 1 x 10⁸Ωcm. Insulation was relatively high. The substrate can be used as the semi-insulating substrate. Crack generation ratio K was 29%. Though this value is considerably high, the substrate is a useful substrate. Radius of curvature R of warpage was 5.3m, and warpage is less.

### [Sample 26 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1×10¹⁹cm⁻³, which is an extremely high value. Iron concentration C_{Fe} was 7× 10¹⁹cm⁻³ , and an extremely large amount of iron was taken in. The specific resistance was 1×10⁵Ωcm. Insulation was extremely low, however, the substrate can be used as the semi-insulating substrate. Crack generation ratio K was 29%. Though this value is considerably high, the substrate is a useful substrate. Radius of curvature R of warpage was 6.0m, and warpage is less.

### [Sample 27 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁹cm⁻³, which is an extremely high value. Iron concentration C_{Fe} was 8×10¹⁹cm⁻³, and an extremely large amount of iron was taken in. The specific resistance was 1×10⁷Ωcm. Insulation was not high, however, the substrate can be used as the semi-insulating substrate. Crack generation ratio K was 28%. Though this value is considerably high, the substrate is a useful substrate. Radius of curvature R of warpage was 5.1m, and warpage is less.

### [Sample 28 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁷cm⁻³, which is a considerably high value. Iron concentration C_{Fe} was 1 × 10¹⁷cm⁻³, and an amount of iron that was taken in is relatively small. The specific resistance was 1×10⁵Ωcm. Insulation was extremely low, however, the substrate can be used as the semi-insulating substrate. Crack generation ratio K was 23%. Though this value is considerably high, the substrate is a useful substrate. Radius of curvature R of warpage was 5.7m, and warpage is less.

### [Sample 29 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1×10¹⁵cm⁻³, which is a low value. Iron concentration C_{Fe} was 1×10¹⁹cm⁻³, and a large amount of iron was taken in. The specific resistance was 1 x 10¹¹Ωcm. Insulation was extremely high, and the substrate can be used as the semi-insulating substrate. Crack generation ratio K was 27%. Though this value is considerably high, the substrate is a useful substrate. Radius of curvature R of warpage was 5.4m, and warpage is less.

### [Sample 30 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3}was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1×10¹⁵cm⁻³, which is a low value. Iron concentration C_{Fe} was 5×10¹⁹cm⁻³ and an extremely large amount of iron was taken in. The specific-resistance-was 1 × 10¹²Ωcm. Insulation was extremely high. Crack generation ratio K was 18%, which is a considerably low value. Radius of curvature R of warpage was 5.7m, and warpage is less.

### [Sample 31 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁹cm⁻³, which is a very high value. Iron concentration C_{Fe} was 7×10¹⁹cm⁻³, and an extremely large amount of iron was taken in. The specific resistance was 1×10⁵Ωcm. Insulation was extremely low. Crack generation ratio K was 27%. Though this value is considerably high, the substrate is still a useful substrate. Radius of curvature R of warpage was 6.0m, and warpage is less.

### [Sample 32 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁹cm⁻³, which is an extremely high value. Iron concentration C_{Fe} was 8×10¹⁹cm⁻³, and an extremely large amount of iron was taken in. The specific resistance was 1 × 10⁷Ωcm. Insulation was not high. Crack generation ratio K was 29%. Though this value is considerably high, the substrate is still a useful substrate. Radius of curvature R of warpage was 5.6m, and warpage is less.

### [Sample 33 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁵cm⁻³, which is a low donor concentration. Iron concentration C_{Fe} was 7×10¹⁹cm⁻³, and an extremely large amount of iron was taken in. The specific resistance was 3×10¹²Ωcm. Insulation was extremely high. Crack generation ratio K was 27%. Though this value is considerably high, the substrate is still a useful substrate. Radius of curvature R of warpage was 5.5m, and warpage is less.

### [Sample 34 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm. The GaAs substrate was removed, to obtain a GaN crystal free-standing substrate having a thickness of 400µm.

Group V/group III ratio R_{5/3} was set to 2.5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1×10¹⁵cm⁻³, which is a low value. As the crystal of II type is obtained, the crystal is doped with a large amount of oxygen. Iron concentration C_{Fe} was 8×10¹⁹cm⁻³, and an extremely large amount of iron was taken in. The specific resistance was 5×10¹²Ωcm. Insulation was extremely high. Crack generation ratio K was 28%. Though this value is considerably high, the substrate is still a useful substrate. Radius of curvature R of warpage was 5.0m, and warpage is less.

### [Sample 35 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 2kPa (0.02atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm.

The GaAs substrate was removed, to obtain a GaN crystal free-standing substrate having a thickness of 400µm. Group V/group III ratio R_{5/3} was set to 5. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 ×10¹⁹cm⁻³. As the crystal of II type is obtained, the crystal is doped with a large amount of oxygen. Iron concentration C_{Fe} was 7×10¹⁹cm⁻³, and an extremely large amount of iron was taken in. The specific resistance was 1 × 10⁵Ωcm. Insulation was extremely low. Crack generation ratio K was 29%. Though this value is considerably high, the substrate is still a useful substrate. Radius of curvature R of warpage was 5.0m, and warpage is less.

### [Sample 36 (Example; II type)]

A parallel-stripe mask having mask width Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 1kPa (0.01 atm), and epitaxial growth was performed until the thickness attains to 400µm or more. A parallel-stripe core (dislocation-concentrated region 5h) of the GaN crystal having a core width of 50µm was formed on the parallel-stripe mask having a mask width of 50µm.

The GaAs substrate was removed, to obtain a GaN crystal free-standing substrate having a thickness of 400µm. Group V/group III ratio R_{5/3} was set to 10. The GaN crystal free-standing substrate included the parallel-stripe core (dislocation-concentrated region 5h) having core width Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁹cm⁻³, which is an extremely high value. As the crystal of II type is obtained, the crystal is doped with a large amount of oxygen. Iron concentration C_{Fe} was 8×10¹⁹cm⁻³, and an extremely large amount of iron was taken in. The specific resistance was 1 × 10⁷Ωcm. Insulation was not high. Crack generation ratio K was 28%. Though this value is considerably high, the substrate is still a useful substrate. Radius of curvature R of warpage was 5.0m, and warpage is less.

### [Sample 37 (Comparative Example; No Mask)]

The buffer layer was formed on a GaAs substrate of 2 inches (50mm) in diameter without forming a mask, and thereafter, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. As the mask was not provided, no core (dislocation-concentrated crystal region 5h) is present. The crystal having a flat C face uniformly grew on the substrate. The GaAs substrate was removed, to obtain a GaN crystal free-standing substrate having a thickness of 400µm.

Group V/group III ratio R_{5/3} was set to 2.5. The crystal face exposed at the surface was the C face. The C face was the flat surface. As the mask was not provided, C face growth was achieved. Donor concentration C_{D} was 1×10¹⁵cm⁻³. As C face growth was achieved, introduction of oxygen (donor) into the crystal is less likely and the donor concentration is extremely low. The crystal was hardly doped with oxygen. Iron concentration C_{Fe} was 1 ×10¹⁷cm⁻³ , and quite an amount of iron was taken in. The specific resistance was 1 × 10⁷Ωcm. Insulation was not high. Crack generation ratio K was 77%, which is an extremely high value. Radius of curvature R of warpage was 1.4m, which means that warpage is exceedingly great. This is because the GaN crystal grew without the mask being formed on the underlying substrate. This substrate is not suitable as the substrate on which a device is to be formed.

### [Sample 38 (Comparative Example; No Mask)]

The buffer layer was formed on a GaAs substrate of 2 inches (50mm) in diameter without forming a mask, and thereafter, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. As the mask was not provided, no core (dislocation-concentrated crystal region 5h) is present. The crystal having a flat C face uniformly grew on the substrate. The GaAs substrate was removed, to obtain a GaN crystal free-standing substrate having a thickness of 400µm.

Group V/group III ratio R_{5/3}was set to 2.5. The crystal face exposed at the surface was the C face. The C face was the flat surface. As the mask was not provided, C face growth was achieved. Donor concentration C_{D} was 1×10¹⁵cm⁻³. As C face growth was achieved, introduction of oxygen (donor) into the crystal is less likely and the donor concentration is extremely low. The crystal was hardly doped with oxygen. Iron concentration C_{Fe} was 1×10¹⁶cm⁻³, and an amount of iron that was taken in was very small. The specific resistance was 1 × 10⁶Ωcm. Insulation was relatively low. Crack generation ratio K was 75%, which is an extremely high value. Radius of curvature R of warpage was 1.6m, which means that warpage is exceedingly great. This is because GaN grew without the mask being formed on the underlying substrate. This substrate is not suitable as the substrate on which a device is to be formed.

### [Sample 39 (Comparative Example; No Mask)]

The buffer layer was formed on a GaAs substrate of 2 inches (50mm) in diameter without forming a mask, and thereafter, a GaN crystal was epitaxially grown. Epitaxial growth temperature Tq was set to 1030°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. As the mask was not provided, no core (dislocation-concentrated crystal region 5h) is present. The crystal having a flat C face uniformly grew on the substrate. The GaAs substrate was removed, to obtain a GaN crystal free-standing substrate having a thickness of 400µm.

Group V/group III ratio R_{5/3}was set to 2.5. The crystal face exposed at the surface was the C face. The C face was the flat surface. As the mask was not provided, C face growth was achieved. Donor concentration C_{D} was 1×10¹⁵cm⁻³. As C face growth was achieved, introduction of oxygen (donor) into the crystal is less likely and the donor concentration is extremely low. The crystal was hardly doped with oxygen. Iron concentration C_{Fe} was 1×10¹⁹cm⁻³, and iron was taken in extremely high concentration. The specific resistance was 1 x 10¹¹Ωcm. Insulation was high. Crack generation ratio K was 88%, which is an extremely high value. Radius of curvature R of warpage was 1.9m, which means that warpage is exceedingly great. This substrate is not suitable as the substrate on which a device is to be formed.

### [Sample 40 (Comparative Example; No Mask)]

The buffer layer was formed on a GaAs substrate of 2 inches (50mm) in diameter without forming a mask, and thereafter, a GaN crystal was epitaxially grown. Epitaxial growth temperature Tq was set to 1030°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. As the mask was not provided, no core (dislocation-concentrated crystal region 5h) is present. The crystal having a flat C face uniformly grew on the substrate. The GaAs substrate was removed, to obtain a GaN crystal free-standing substrate having a thickness of 400µm.

Group V/group III ratio R_{5/3}was set to 2.5. The crystal face exposed at the surface was the C face. The C face was the flat surface. As the mask was not provided, C face growth was achieved. Donor concentration C_{D} was 1×10¹⁵cm⁻³. As C face growth was achieved, introduction of oxygen (donor) into the crystal is less likely and the donor concentration is extremely low. The crystal was hardly doped with oxygen. Iron concentration C_{Fe} was 5×10¹⁹cm⁻³, and iron was taken in high concentration. The specific resistance was 1×10¹²Ωcm. Insulation was high. Crack generation ratio K was 97%, which is an extremely high value. Radius of curvature R of warpage was 1.8m, which means that warpage is exceedingly great. This substrate is not suitable as the substrate on which a device is to be formed.

### [Sample 41 (Comparative Example; No Mask)]

The buffer layer was formed on a GaAs substrate of 2 inches (50mm) in diameter without forming a mask, and thereafter, a GaN crystal was epitaxially grown. Epitaxial growth temperature Tq was set to 1010°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. As the mask was not provided, no core (dislocation-concentrated crystal region 5h) is present. The crystal having a flat C face uniformly grew on the substrate. The GaAs substrate was removed, to obtain a GaN crystal free-standing substrate having a thickness of 400µm.

Group V/group III ratio R_{5/3} was set to 2.5. The crystal face exposed at the surface was the C face. The C face was the flat surface. As the mask was not provided, C face growth was achieved. Donor concentration C_{D} was 1×10¹⁷cm⁻³. Though C face growth was achieved, the donor concentration was considerably high. Iron concentration C_{Fe} was 1 × 10¹⁷cm⁻³, and quite an amount of iron was taken in. The specific resistance was 1 x 10⁵Ωcm. Insulation was very low. Crack generation ratio K was 68%, which is a high value. Radius of curvature R of warpage was 1.4m, which means that warpage is exceedingly great. This substrate is not suitable as the substrate on which a device is to be formed.

### [Sample 42 (Comparative Example; No Mask)]

The buffer layer was formed on a GaAs substrate of 2 inches (50mm) in diameter without forming a mask, and thereafter, a GaN crystal was epitaxially grown. Epitaxial growth temperature Tq was set to 1010°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. As the mask was not provided, no core (dislocation-concentrated crystal region 5h) is present. The crystal having a flat C face uniformly grew on the substrate. The GaAs substrate was removed, to obtain a GaN crystal free-standing substrate having a thickness of 400µm.

Group V/group III ratio R_{5/3} was set to 2.5. The crystal face exposed at the surface was the C face. The C face was the flat surface. As the mask was not provided, C face growth was achieved. Donor concentration C_{D} was 1 × 10¹⁷cm⁻³. Though C face growth was achieved, the donor concentration was considerably high. Iron concentration C_{Fe}was 1 ×10¹⁹cm⁻³, and iron was taken in high concentration. The specific resistance was 1 × 10⁷Ωcm. Insulation was not high. Crack generation ratio K was 90%, which is an extremely high value. Radius of curvature R of warpage was 1.4m, which means that warpage is exceedingly great. This substrate is not suitable as the substrate on which a device is to be formed.

### [Sample 43 (Comparative Example; No Mask)]

The buffer layer was formed on a GaAs substrate of 2 inches (50mm) in diameter without forming a mask, and thereafter, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. As the mask was not provided, no core (dislocation-concentrated crystal region 5h) is present. The crystal having a flat C face uniformly grew on the substrate. The GaAs substrate was removed, to obtain a GaN crystal free-standing substrate having a thickness of 400µm.

Group V/group III ratio R_{5/3} was set to 2.5. The crystal face exposed at the surface was the C face. The C face was the flat surface. As the mask was not provided, C face growth was achieved. Donor concentration C_{D} was 1 × 10¹⁷cm⁻³. Though C face growth was achieved, the donor concentration was considerably high. Iron concentration C_{Fe} was 5×10¹⁹cm⁻³, and iron was taken in high concentration. The specific resistance was 1 × 1 0⁸Ωcm. Insulation was relatively high. Crack generation ratio K was 95%, which is an extremely high value. Radius of curvature R of warpage was 1.6m, which means that warpage is exceedingly great. This is because the mask was not formed. This substrate is not suitable as the substrate on which a device is to be formed.

### [Sample 44 (Example; I Type Dot Type)]

A dot mask having mask diameter Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1100°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A dot core (dislocation-concentrated crystal region 5h) of the GaN crystal having a core diameter of 50µm was formed on the dot mask having a mask diameter of 50µm.

The GaAs substrate was removed, to obtain a GaN crystal free-standing substrate having a thickness of 400µm. Group V/group III ratio R_{5/3} was set to 2.5. The GaN crystal free-standing substrate included the dot core (dislocation-concentrated crystal region 5h) having core diameter Ds of 50µm and repeated at core interval Dw of 500µm. The crystal type of the core (dislocation-concentrated crystal region 5h) was the inversion layer. The crystal face type was I type. As growth temperature Tq was high, I type was obtained. Donor concentration C_{D} was 1×10¹⁵cm⁻³, which is an extremely low donor concentration value. Iron concentration C_{Fe} was 1 × 10¹⁷cm⁻³, and an amount of iron that was taken in is not great. The specific resistance was 1 × 10⁷Ωcm. Insulation was relatively low, because the iron concentration was low. Nevertheless, the substrate can be used as the semi-insulating substrate. Crack generation ratio K was 20%, which is extremely low. Radius of curvature R of warpage was 3.2m.

### [Sample 45 (Example; II Type Dot Type)]

A dot mask having mask diameter Ds of 50µm was formed at mask interval Dw of 500µm on a GaAs substrate of 2 inches (50mm) in diameter. After the buffer layer was formed, a GaN crystal was epitaxially grown. Epitaxial growth temperature Tq was set to 1050°C, NH₃ partial pressure P_{NH3} was set to 10kPa (0.1atm), and GaCl partial pressure P_{GaCl} was set to 4kPa (0.04atm), and epitaxial growth was performed until the thickness attains to 400µm or more. A dot core (dislocation-concentrated crystal region 5h) of the GaN crystal having a core diameter of 50µm was formed on the dot mask having a mask diameter of 50µm. The GaAs substrate was removed, to obtain a GaN crystal free-standing substrate having a thickness of 400µm.

Group V/group III ratio R_{5/3} was set to 2.5. The GaN crystal free-standing substrate included the dot core (dislocation-concentrated crystal region 5h) having core diameter Ds of 50µm and repeated at core interval Dw of 500µm. The crystal type of the core (dislocation-concentrated crystal region 5h) was the inversion layer. The crystal face type was II type. As growth temperature Tq was relatively low, II type was obtained. Donor concentration C_{D} was 1 × 10¹⁵cm⁻³, which is an extremely low donor concentration value. Iron concentration C_{Fe} was 1 × 10¹⁷cm⁻³ , and an amount of iron that was taken in is not great. The specific resistance was 1×10⁷Ωcm. Insulation was not so high. Nevertheless, the substrate can be used as the semi-insulating substrate. Crack generation ratio K was 18%. A good semi-insulating substrate in which crack generation is less likely could be obtained. Radius of curvature R of warpage was 4.0m, and warpage is less.

### [Example B: Examples of Devices Including Semi-Insulating Substrate]

### [Fabrication of Devices Including Stripe-Core-Type Semi-Insulating Substrate]

### [Device Sample 46 (Example; I Type)]

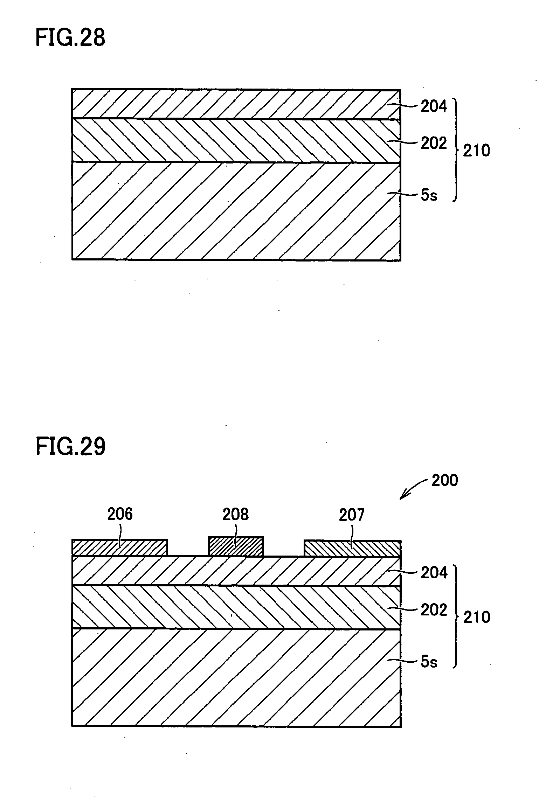

An epitaxial wafer having an HEMT (high electron mobility transistor) structure was fabricated with an organometallic vapor phase epitaxy (OMVPE) method on the semi-insulating GaN substrate of the crystal type of I and a diameter of 3 inches fabricated with sample 3 (the stripe core (dislocation-concentrated crystal region 5h) interval of 500µm, the core width of 50µm, and the specific resistance of 1×10⁷Ωcm) (Fig. 28). Specifically, referring to Fig. 28, a semi-insulating GaN substrate 5s was placed in a reactor (not shown) of an OMVPE apparatus, a gas containing hydrogen, nitrogen and ammonia was supplied into the reactor, and heat treatment was performed for 20 minutes while the temperature of semi-insulating GaN substrate 5s was held at 1100°C. Thereafter, the temperature of semi-insulating GaN substrate 5s was raised to 1130°C and ammonia and trimethylgallium (TMG) were supplied into the reactor, to grow a GaN epitaxial layer 202 to a thickness of 1.5µm on semi-insulating GaN substrate 5s. Trimethylaluminum (TMA), TMG, and ammonia were supplied into the reactor, to grow an AlGaN epitaxial layer 204 having Al composition of 20% to a thickness of 30nm on GaN epitaxial layer 202. An epitaxial substrate 210 was fabricated through these steps.

Referring next to Fig. 29, an HEMT device 200 was fabricated through the following steps. A source electrode 206 and a drain electrode 207 were fabricated on AlGaN epitaxial layer 204 of epitaxial substrate 210 with photolithography, EB (electron beam) vapor deposition, and lift-off. Ti/Al/Ti/Au (respective thicknesses were 20/100/20/300nm) were used for the electrodes. After lift-off, heat treatment for alloying was performed at 600°C for 1 minute.

Thereafter, a gate electrode 208 was fabricated through the similar steps. Gate electrode 208 was fabricated such that it is arranged in a direction parallel to the stripe core (dislocation-concentrated crystal region 5h) and not formed on the stripe core. Ni/Au (respective thicknesses were 50/500nm) were used for gate electrode 208. A gate length was 2µm. (This is adopted as a device sample 46).

### [Device Sample 47 (Comparative Example)]

To prepare a comparative sample 47, an HEMT structure was epitaxially grown on an Fe-doped semi-insulating random core substrate in a similar manner, to fabricate an HEMT. The random core refers to a crystal in which dislocation-concentrated crystal regions 5h are randomly distributed. When facet growth on the underlying substrate is attained without forming a mask, facet pits are randomly generated, which are turned to dislocation-concentrated crystal regions 5h. Dislocation-concentrated crystal regions 5h (cores) are thus randomly distributed.

### [Device Sample 48 (Comparative Example)]

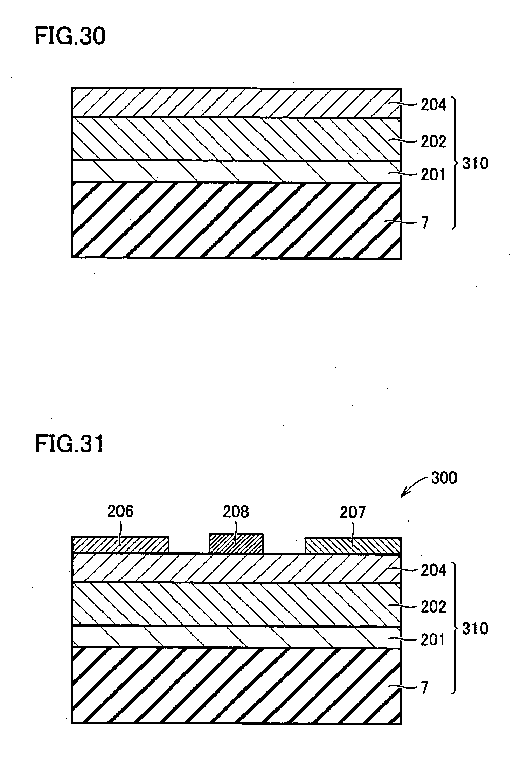

In addition, referring to Fig. 30, to prepare a device sample 48, an epitaxial layer for forming an HEMT structure grew on a sapphire substrate 7 in a similar manner. In the step of growing the epitaxial layer, sapphire substrate 7 was subjected to heat treatment at 1170°C for 10 minutes, and then a GaN seed crystal layer 201 grew. Thereafter, as in the case of the GaN substrate, GaN epitaxial layer 202 and AlGaN epitaxial layer 204 grew, to fabricate an epitaxial substrate 310. Then, referring to Fig. 31, an HEMT device 300 was fabricated through similar steps (Fig. 31).

Gate leakage currents of device samples 46, 47 and 48 were compared with each other. At gate voltage 5V, a low gate current density of 1 x 10⁶A/cm² was obtained in sample 46. On the other hand, the gate current density was 1×10³A/cm² and 1×10²A/cm² in samples 47 and 48 respectively, and the gate leakage current significantly increased as compared with sample 46. As the gate leakage current is smaller, pinch-off of the transistor is better and hence a high-performance transistor can be realized.

The reason why the gate leakage current increased in device sample 47 seems to be that the random core is present under the gate electrode and hence the leakage current originating from dislocation increased.

The reason why the gate leakage current increased in device sample 48 seems to be that, as the substrate is made of sapphire, the dislocation density in the epitaxial layer became high (up to 1×10⁹/cm²) and hence the leakage current originating from dislocation became great. From the foregoing, according to the present invention, a high-performance HEMT and an HEMT epitaxial substrate achieving a small gate leakage current can be realized.

### [Example C: Examples of Devices Including Dot-Type Semi-Insulating Substrate]

### [Fabrication of Devices Including Dot-Core-Type Semi-Insulating Substrate]

### [Device Sample 49 (Example; I Type Dot-type]

An epitaxial wafer having an HEMT (high electron mobility transistor) structure was fabricated with an organometallic vapor phase epitaxy (OMVPE) method on the 2-inch semi-insulating GaN substrate of the crystal type of I fabricated with sample 44 (the dot core (dislocation-concentrated crystal region 5h) interval of 500µm, the core diameter of 50µm, and the specific resistance of 1×10⁷Ωcm) (Fig. 28). Specifically, referring to Fig. 28, semi-insulating GaN substrate 5s was placed in a reactor of an OMVPE apparatus, a gas containing hydrogen, nitrogen and ammonia was supplied into the reactor, and heat treatment was performed for 20 minutes while the temperature of semi-insulating GaN substrate 5s was held at 1100°C. Thereafter, the temperature of semi-insulating GaN substrate 5s was raised to 1130°C and ammonia and trimethylgallium (TMG) were supplied into the reactor, to grow GaN epitaxial layer 202 to a thickness of 1.5µm on semi-insulating GaN substrate 5s. Trimethylaluminum (TMA), TMG, and ammonia were supplied into the reactor, to grow AlGaN epitaxial layer 204 having Al composition of 20% to a thickness of 30nm on GaN epitaxial layer 202. Epitaxial substrate 210 was fabricated through these steps.

Referring next to Fig. 29, HEMT device 200 was fabricated through the following steps. Source electrode 206 and drain electrode 207 were fabricated on AlGaN epitaxial layer 204 of epitaxial substrate 210 with photolithography, EB vapor deposition, and lift-off. Ti/AUTi/Au (respective thicknesses were 20/100/20/300nm) were used for the electrodes. After lift-off, heat treatment for alloying was performed at 600°C for 1 minute.

Thereafter, gate electrode 208 was fabricated through the similar steps. Gate electrode 208 was fabricated such that it is not formed on a dot core region (dislocation-concentrated crystal region 5h). Ni/Au (respective thicknesses were 50/500nm) were used for gate electrode 208. A gate length was 2µm. (This is adopted as a device sample 49).

### [Device Sample 50 (Comparative Example)]

To prepare a comparative sample 50, an HEMT structure was epitaxially grown on an Fe-doped semi-insulating random core substrate in a similar manner, to fabricate an HEMT.

### [Device Sample 51 (Comparative Example)]

In addition, referring to Fig. 30, to prepare a device sample 51, an epitaxial layer for forming an HEMT structure grew on sapphire substrate 7 in a similar manner. In the step of growing the epitaxial layer, sapphire substrate 7 was subjected to heat treatment at 1170°C for 10 minutes, and then GaN seed crystal layer 201 grew. Thereafter, as in the case of the semi-insulating GaN substrate, GaN epitaxial layer 202 and AlGaN epitaxial layer 204 grew, to fabricate epitaxial substrate 310. Then, referring to Fig. 31, HEMT device 300 was fabricated through similar steps.

Gate leakage currents of device samples 49, 50 and 51 were compared with each other. At gate voltage 5V, a low gate current density of 1×10⁶A/cm² was obtained in sample 49. On the other hand, the gate current density was 1×10³A/cm² and 1×10²A/cm² in samples 50 and 51 respectively, and the gate leakage current significantly increased as compared with sample 49. As the gate leakage current is smaller, pinch-off of the transistor is better and hence a high-performance transistor can be realized.

The reason why the gate leakage current increased in device sample 50 seems to be that the random core is present under the gate electrode and hence the leakage current originating from dislocation increased.

The reason why the gate leakage current increased in device sample 51 seems to be that, as the substrate is made of sapphire, the dislocation density in the epitaxial layer became high (up to 1 × 10⁹/cm²) and the leakage current originating from dislocation became great. From the foregoing, according to the present invention, a high-performance HEMT and an HEMT epitaxial substrate achieving a small gate leakage current can be realized.

Fig. 22 shows values of temperatures and group V/group III ratios R_{5/3} of examples corresponding to samples 1 to 36, 44, and 45 above, with white circles (II type) and white triangles (I type). All these values are located in an area enclosed by a dashed line (1040°C to 1150°C and group V/group III ratio R_{5/3} = 1 to 10). Some of the temperatures and group V/group III ratios R_{5/3} of comparative examples 37 to 43 are included in a frame shown with the dashed line, and others are not. These comparative examples are not suitable in terms of crack or warpage, even though the values are located within the frame shown with the dashed line, because the mask was not provided. The comparative examples are provided in order to confirm effects of the mask.

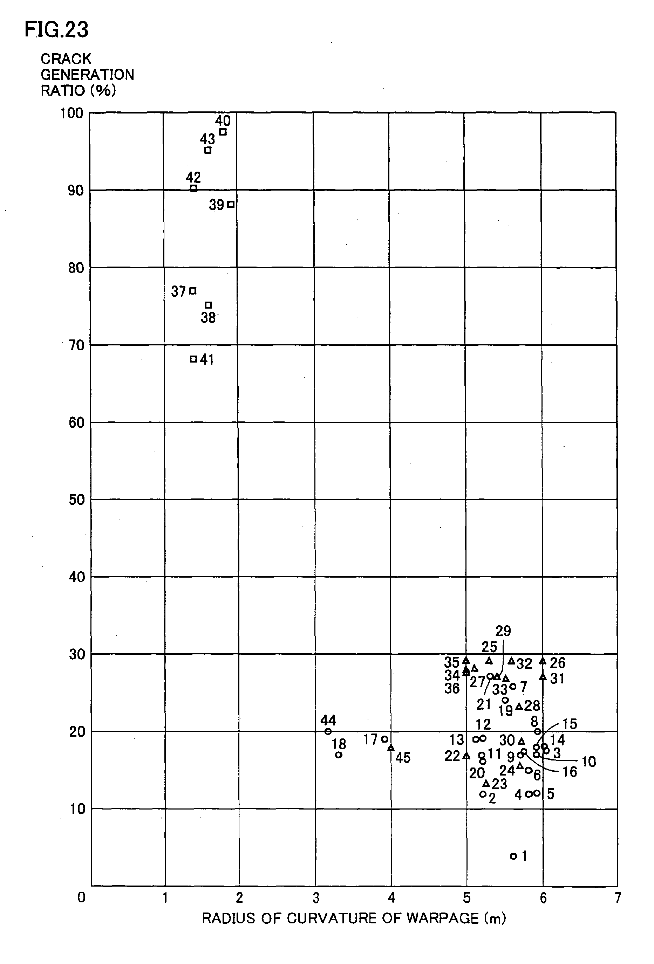

Fig. 23 shows the warpage and the crack generation ratio of samples 1 to 45 with points, the abscissa representing the radius of curvature of warpage (m) and the ordinate representing the crack generation ratio (%). Numerics represent sample numbers. White circles indicate samples 1 to 21 and 44 of the I type. White triangles indicate samples 22 to 36 and 45 of the II type. White squares correspond to samples 37 to 43 according to the comparative examples.

Samples 37 to 43 according to the comparative examples have strong warpage (radius of curvature from 1m to 2m) and the crack generation ratio from 68 to 97%, and they are not suitable for the substrate for fabricating a semiconductor device thereon. This is because the mask was not provided on the underlying substrate.

Comparing the I type with the II type, the warpage (radius of curvature) is in a range from 5m to 6m, and there is not much difference therebetween. The radii of curvatures of warpage of both of the I and II types are not smaller than 3m, and they are distributed in a range from 3m to 7m. The crack generation ratios are not larger than 30%. The crack generation ratio of the I type is in a range from 4% to 27%, and most of them are distributed in a range from 10% to 20%. The crack generation ratio of the II type is in a range from 13% to 29%, and most of them are in a range from 25% to 29%. From a point of view of the crack, the I type is superior to the II type. Both of the I type and the II type are applicable for a semi-insulating substrate.

Fig. 27 shows distribution of donor concentrations (cm⁻³) and iron (Fe) concentrations (cm⁻³) of samples 1 to 45 in a graph, in which the abscissa represents the donor (oxygen) concentration and the ordinate represents the iron concentration. White circles indicate the I type, white triangles indicate the II type, and white squares indicate the comparative examples. Numerics represent sample numbers. It can be seen that the II type (white triangles) is high in the donor concentration. Though some samples of the I type are high in the donor concentration (samples 19, 20 and 21), a great majority of samples of the I type are low in the donor concentration.

As to the II type, the amount of iron doping increases generally in proportion to the donor amount. On the other hand, as to the I type, the amount of iron can be great in spite of a small amount of donor. In this regard as well, the I type is superior.

In addition, dislocation density of samples 1 to 36 of the I and II types and samples 37 to 43 according to the comparative examples was measured through etching with an etchant composed of a phosphoric acid and a sulfuric acid at 200°C. Measurement was conducted by using a differential interference optical microscope at 100X and by counting the number of etch pits in an area of 100×100µm. Consequently, dislocation densities (etch pit densities) of samples 37 to 43 according to the comparative examples are all in a range from 2×10⁷ to 10⁸/cm², whereas dislocation densities of samples 1 to 36 are not higher than 5×10⁶/cm². In particular, dislocation density of the sample having the radius of curvature of warpage of the crystal exceeding 4m is not higher than 2x 10⁶/cm² and dislocation density of the sample having the radius of curvature of warpage of the crystal exceeding 5m is not higher than the order of 10⁵/cm². The dislocation density of the sample having the crystal face type II was approximately half that of the I type. Despite the fact that sample 21 has the crystal face type of I, however, sample 21 has the dislocation density approximately half that of samples 2, 11, 12, and 20 substantially equivalent in the radius of curvature, and sample 21 is identical in dislocation density to sample 25 of II type having similar radius of curvature, because sample 21 experienced facet face growth in an initial stage of growth. When a sapphire substrate or an SiC substrate is used instead of the GaAs substrate used for fabricating samples 1 to 36 as well, a substrate having a crystal face, an Fe concentration, a donor concentration, a specific resistance, a crack generation ratio, and a radius of curvature of warpage equivalent to those of samples 1 to 36 was obtained. Moreover, as a result of growth under the conditions the same as those for samples 1 to 36 with the use of the GaN substrate used for samples 1 to 36 as the underlying substrate, a substrate having a crystal face, an Fe concentration, a donor concentration, a specific resistance, a crack generation ratio, and a radius of curvature of warpage equivalent to those of samples 1 to 36 was obtained.

Although the present invention has been described and illustrated in detail, it is clearly understood that the same is by way of illustration and example only and is not to be taken by way of limitation, the scope of the present invention being interpreted by the terms of the appended claims.

## Claims

1. A method of manufacturing a semi-insulating nitride semiconductor substrate for obtaining a free-standing semi-insulating nitride semiconductor substrate having a specific resistance not smaller than 1×10⁵Ωcm and a thickness not smaller than 100µm, comprising the steps of:
forming on an underlying substrate (1), a mask (3) in which dotted or striped coating portions having a width or a diameter Ds from 10µm to 100µm are arranged at an interval Dw from 250µm to 2000µm;
growing a nitride semiconductor crystal (5) on said underlying substrate (1) with an HVPE method at a growth temperature from 1040°C to 1150°C by supplying a group III raw material gas and a group V raw material gas of which group V/group III ratio R_{5/3} is set to 1 to 10 and a gas containing iron; and
removing said underlying substrate (1).

2. The method of manufacturing a semi-insulating nitride semiconductor substrate according to claim 1, wherein
said nitride semiconductor crystal (5) having a substantially flat crystal surface except for said coating portion grows by setting the group V/group III ratio R_{5/3} to 1 to 5 and setting the growth temperature to 1090°C to 1150°C.

3. The method of manufacturing a semi-insulating nitride semiconductor substrate according to claim 1, wherein
said nitride semiconductor crystal (5) having a facet (5f) of which bottom is located at said coating portion and peak is located in a position intermediate between adjacent said coating portions grows by setting the group V/group III ratio R_{5/3} to 1 to 10 and setting the growth temperature to 1040°C to 1070°C.

4. A semi-insulating nitride semiconductor substrate having a specific resistance not smaller than 1 x 10⁵Ωcm, a thickness not smaller than 100µm, and a radius of curvature of warpage not smaller than 3m, comprising:
a dotted or striped dislocation-concentrated crystal region (5h, 5h) having a diameter or a width Ds from 10µm to 100µm and repeated at an interval Dw from 250µm to 2000µm;
a dislocation-reduced facet growth crystal region (5z, 5z) repeatedly present between adjacent said dislocation-concentrated crystal regions (5h, 5h); and
a dislocation-reduced C face growth crystal region (5y) present between said dislocation-reduced facet growth crystal regions (5z, 5z).

5. A nitride semiconductor epitaxial substrate having a radius of curvature of warpage not smaller than 3m, comprising:
a semi-insulating nitride semiconductor substrate (5s) including a dotted or striped dislocation-concentrated crystal region (5h, 5h) having a diameter or a width Ds from 10µm to 100µm and repeated at an interval Dw from 250µm to 2000µm, a dislocation-reduced facet growth crystal region (5z, 5z) repeatedly present between adjacent said dislocation-concentrated crystal regions (5h, 5h), and a dislocation-reduced C face growth crystal region (5y) present between said dislocation-reduced facet growth crystal regions (5z, 5z), and having a specific resistance not smaller than 1×10⁵Ωcm and a thickness not smaller than 100µm; and
a nitride semiconductor epitaxial layer (202, 204) provided on said semi-insulating nitride semiconductor substrate (5s).

6. A field-effect transistor, comprising:
a semi-insulating nitride semiconductor substrate (5s) including a dotted or striped dislocation-concentrated crystal region (5h, 5h) having a diameter or a width Ds from 10µm to 100µm and repeated at an interval Dw from 250µm to 2000µm, a dislocation-reduced facet growth crystal region (5z, 5z) repeatedly present between adjacent said dislocation-concentrated crystal regions (5h, 5h), and a dislocation-reduced C face growth crystal region (5y) present between said dislocation-reduced facet growth crystal regions (5z, 5z), and having a specific resistance not smaller than 1 × 10⁵Ωcm;
a nitride semiconductor epitaxial layer (202, 204) provided on said semi-insulating nitride semiconductor substrate (5s); and
a gate electrode (208), a source electrode (206) and a drain electrode (207) provided on said nitride semiconductor epitaxial layer (202, 204), and
said gate electrode (208) being formed on a crystal region other than said dislocation-concentrated crystal region (5h).
